(19) Europäisches Patentamt
European Patent Office
Office européen des brevets

(11) EP 2 615 144 B1

# (12) EUROPEAN PATENT SPECIFICATION

(45) Date of publication and mention of the grant of the patent:
**17.10.2018 Bulletin 2018/42**

(21) Application number: **11823386.5**

(22) Date of filing: **18.08.2011**

(51) Int Cl.:
***C09J 7/29*** (2018.01)
***H01L 51/52*** (2006.01)
***C09J 121/00*** (2006.01)
***C09D 183/16*** (2006.01)

(86) International application number:
**PCT/JP2011/068651**

(87) International publication number:
**WO 2012/032907 (15.03.2012 Gazette 2012/11)**

## (54) ADHESIVE SHEET AND ELECTRONIC DEVICE

KLEBEFOLIE UND ELEKTRONISCHE VORRICHTUNG

FEUILLE ADHÉSIVE ET DISPOSITIF ÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.09.2010 JP 2010200073**

(43) Date of publication of application:
**17.07.2013 Bulletin 2013/29**

(73) Proprietor: **Lintec Corporation**
**Tokyo 173-0001 (JP)**

(72) Inventors:
- **UEMURA, Kazue**
  **Tokyo 173-0001 (JP)**
- **AMINO, Yumiko**
  **Tokyo 173-0001 (JP)**
- **SUZUKI, Yuta**
  **Tokyo 173-0001 (JP)**
- **ONO, Yoshitomo**
  **Tokyo 173-0001 (JP)**
- **NAKAJIMA, Emi**
  **Tokyo 173-0001 (JP)**

(74) Representative: **Gille Hrabal**
**Brucknerstrasse 20**
**40593 Düsseldorf (DE)**

(56) References cited:
**EP-A1- 2 045 355**
**WO-A1-2010/093010**
**WO-A1-2010/107018**
**WO-A1-2010/107018**
**JP-A- 10 024 520**
**JP-A- 2000 246 830**
**JP-A- 2003 118 030**
**JP-A- 2004 066 730**
**JP-A- 2007 197 517**
**JP-A- 2007 237 588**
**JP-A- 2009 190 186**
**JP-A- 2011 000 718**
**JP-A- 2011 143 550**
**JP-A- 2011 143 551**

- **OHISHI T: "Gas barrier characteristics of a polysilazane film formed on an ITO-coated PET substrate", JOURNAL OF NON-CRYSTALLINE SOLIDS, NORTH-HOLLAND PHYSICS PUBLISHING. AMSTERDAM, NL, vol. 330, no. 1-3, 15 November 2003 (2003-11-15), pages 248-251, XP004471734, ISSN: 0022-3093, DOI: 10.1016/J.JNONCRYSOL.2003.09.022**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 615 144 B1

## Description

[Technical Field]

The present invention relates to an adhesive sheet and an electronic device provided with the adhesive sheet as an electronic device member.

[Background Art]

In recent years, organic electronics are watched as a technology capable of forming a display, a circuit, a battery, and the like on a flexible plastic substrate at low temperatures close to room temperature by adopting a coating or printing process, and research and development of various organic devices are being advanced.

For example, organic EL elements capable of undergoing high-luminance light emission by low-voltage direct current drive are watched as light emitting elements which are used for liquid crystal displays and electroluminescence (EL) displays. For these displays, for the purpose of realizing thinning, weight reduction, flexibilization, and the like, it is investigated to use a transparent plastic film as a substrate having an electrode.

Now, such an organic EL element involved such a problem that when driven for a fixed time, light emission characteristics such as light emission luminance, light emission efficiency, light emission uniformity, etc. are deteriorated as compared with those in the initial stage. As causes for this problem, oxidation of the electrode and modification of an organic substance to be caused due to oxygen, water vapor, or the like which has penetrated into the organic EL element, oxidative decomposition of an organic material to be caused due to heat at the time of drive, and the like may be considered. The plastic film which is used as the substrate involves such problems that it is liable to transmit oxygen, water vapor, or the like therethrough; and that it is liable to cause deterioration of the organic EL element.

In order to solve the foregoing problems, it is investigated to encapsulate the organic EL element with an adhesive sheet having barrier properties so as to suppress the contact with oxygen or water vapor. As a method for imparting barrier properties, a silica vapor deposited film is generally known. However, since huge equipment is required for the vapor deposition, there was involved a problem from the cost standpoint.

In addition, a method for manufacturing a gas barrier film by forming a polysilazane film on at least one surface of a film and subjecting the polysilazane film to a plasma treatment is disclosed (see Patent Document 1). However, there is involved such a problem that when this gas barrier film is used as a base material, cracking is generated in the gas barrier layer, or other problem.

Besides, for example, an adhesive film using a polyisobutylene based resin as an adhesive layer is disclosed as an adhesive sheet for organic device (see Patent Document 2). However, the adhesive layer of Patent Document 2 is weak against high temperatures or ultraviolet rays, or the like, so that there was involved such a problem that when the organic EL element or device is exposed to a high temperature or ultraviolet ray irradiation due to long-term drive or drive environment, the resin itself of the adhesive layer is deteriorated, resulting in a possibility to cause lowering of performances of the adhesive film and deterioration of the organic EL element following this.

A gas barrier film and an organic device such as an organic EL device, a liquid crystal device, a touch panel or a solar cell comprising the same is disclosed (see Patent Document 3). The gas barrier film comprises at least one silicon hydronitride layer and at least one silicon nitride layer on a surface of a flexible film.

[Prior Art Documents]

[Patent Documents]

[Patent Document 1] JP-A-2007-237588
[Patent Document 2] JP-A-2007-197517
[Patent Document 3] EP 2 045 355 A1

[Summary of the Invention]

[Problems To Be Solved by the Invention]

In order to solve the foregoing problems, the present invention has been made, and an object thereof is to provide an adhesive sheet with excellent gas barrier properties, resistance to folding and transparency and an electronic device provided with the adhesive sheet as an electronic device member.

[Means for Solving the Problems]

The present inventors have found that an adhesive sheet in which a gas barrier layer constituting the adhesive sheet is constituted of a material containing at least an oxygen atom and a silicon atom, and existing proportions of an oxygen atom, a nitrogen atom, and a silicon atom in a surface layer part of the gas barrier layer and a film density fall within specified ranges, respectively may solve the foregoing problems. Specifically, the subject-matter of the present invention is defined in claims 1-14 as attached. Embodiments described herein which are not covered by the claims merely serve to illustrate the technical context of the present invention.

[Effects of the Invention]

The adhesive sheet according to the present invention is excellent in gas barrier properties, resistance to folding, and transparency. Accordingly, the adhesive sheet according to the present invention can be suitably used for electronic devices such as displays, solar batteries, etc.

[Brief Description of the Drawings]

FIG. 1 is a view showing an example of a configuration of an adhesive sheet according to the present invention.
FIG. 2 is a view showing an example of an organic EL element using an adhesive sheet according to the present invention.

[Modes for Carrying Out the Invention]

[Adhesive sheet]

The adhesive sheet according to the present invention comprises a base material having thereon at least a gas barrier layer and an adhesive layer. FIG. 1 is a view showing an example of a configuration of an adhesive sheet according to the present invention. Though the adhesive sheet according to the present invention comprises at least a base material, a gas barrier layer, and an adhesive layer, so far as the adhesive layer exists as an outermost layer, the order of lamination does not matter. For example, as in (A1) of FIG. 1, there is exemplified an adhesive sheet 1 in which a gas barrier layer 3 is laminated on one surface of a base material 2, and an adhesive layer 4 is laminated on the gas barrier layer 3. In addition, as in an adhesive sheet 1a in (A2) of FIG. 1, there may be adopted a configuration in which the adhesive layer 4 is laminated on one surface of the base material 2, and the gas barrier layer 3 is formed on the opposite side of the base material 2 from the adhesive layer 4.

Besides, as in (B) of FIG. 1, there may be formed an adhesive sheet 1b having an adhesive layer on both surfaces thereof by laminating the gas barrier layer 3 and an adhesive layer 4a on one surface of the base material 2 and further providing an adhesive layer 4b on the surface of the base material on the opposite side.

Furthermore, as in (C) of FIG. 1, there may be formed an adhesive sheet 1c in which an adhesive layer 4a is provided between two gas barrier layers 3a and 3b wherein the gas barrier layer 3a is laminated on one surface of a base material 2a, and the gas barrier layer 3b is laminated on one surface of a base material 2b, and adhesive layers 4b and 4c are provided on the opposite sides of the base materials 2a and 2b from the surfaces on which the gas barrier layers are provided, respectively. In this adhesive sheet 1c, not only the adhesive layer 4a adheres to the two gas barrier layers 3a and 3b, respectively, but in the case where an impact is applied from the outside, it is able to play a role in absorbing the impact to protect the gas barrier layers 3a and 3b.

Incidentally, while illustration is omitted in FIG. 1, the "other layer" than the base material, the gas barrier layer, and the adhesive layer may be provided. A position at which the subject other layer is laminated is not particularly limited, and it is properly chosen depending upon a role of each layer.

(1) A base material, (2) a gas barrier layer, (3) an adhesive layer, and (4) other layer are hereunder successively described.

[(1) Base material]

The base material according to the present invention is not particularly limited so far as it is a material other than the polysilazane compound, has a self-supporting characteristic, and coincides with the object of the present invention. Examples of the base material which is used include polyimides, polyamides, polyamide-imides, polyphenylene ethers, polyetherketones, polyetheretherketones, polyolefins, polyesters, polycarbonates, polysulfones, polyethersulfones, polyphenylene sulfides, polyarylates, acrylic resins, cycloolefin based polymers, aromatic polymers, and the like.

Of these, polyesters, polyamides, or cycloolefin based polymers are preferable because they are excellent in transparency and have general-purpose properties, with polyesters or cycloolefin based polymers being more preferable.

Examples of the polyesters include polyethylene terephthalate, polybutylene terephthalate, polyethylene naphthalate, polyarylate, and the like.

Examples of the polyamides include wholly aromatic polyamide, nylon 6, nylon 66, nylon copolymers, and the like.

Examples of the cycloolefin based polymers include norbornene based polymers, monocyclic cyclic olefin based polymers, cyclic conjugated diene based polymers, vinyl alicyclic hydrocarbon polymers, and hydrides thereof, and the like. Specific examples of commercially available products thereof include APEL (an ethylene-cycloolefin copolymer, manufactured by Mitsui Chemicals, Inc.), ARTON (a norbornene based polymer, manufactured by JSR Corporation), ZEONOR (a norbornene based polymer, manufactured by Zeon Corporation), and the like.

Though a thickness of the base material is not particularly limited, it is preferably from 0.5 to 500 μm, more preferably from 1 to 200 μm, and still more preferably from 10 to 100 μm.

[(2) Gas barrier layer]

The gas barrier layer of the adhesive sheet according to the present invention satisfies at least the following requirements (a) to (c).

(a) The gas barrier layer is constituted of a material containing at least an oxygen atom and a silicon atom.

(b) In a surface layer part of the gas barrier layer, an existing proportion of an oxygen atom is from 60 to 75 %, an existing proportion of a nitrogen atom is from 0 to 10 %, and an existing proportion of a silicon atom is from 25 to 35 % relative to a total existing amount of the oxygen atom, the nitrogen atom, and the silicon atom.

(c) A film density in the surface layer part of the gas barrier layer is from 2.4 to 4.0 g/cm$^3$.

By using a gas barrier layer satisfying the foregoing requirements (a) to (c), it is possible to obtain an adhesive sheet with excellent gas barrier properties, resistance to folding and transparency.

The matter that the adhesive sheet according to the present invention has excellent gas barrier properties can be confirmed from the fact that its transmission rate of a gas such as water vapor, etc. is remarkably small. A water vapor transmission rate of the gas barrier layer is preferably not more than 1.0 g/m$^2$/day, more preferably not more than 0.5 g/m$^2$/day, and still more preferably not more than 0.1 g/m$^2$/day under an atmosphere at 40°C and a relative humidity of 90 %. Incidentally, the water vapor transmission rate can be measured using a known gas transmission rate measuring apparatus, and in the present invention, it means a value measured by the method described in the Examples (hereinafter the same).

In addition, the matter that the adhesive sheet according to the present invention is excellent in resistance to folding, so that even when subjected to folding or the like, it is able to keep the gas barrier properties can be confirmed from the fact that when the adhesive sheet is folded double, applied with a pressure, and then again opened, the gas barrier layer in a folded portion is not deteriorated, and the water vapor transmission rate is not substantially lowered. The adhesive sheet according to the present invention is excellent in keeping the gas barrier properties even after folding in comparison with the case where an inorganic film having the same thickness is laminated as a gas barrier layer.

(Requirement (a))

As a material satisfying the foregoing requirement (a), a polysilazane compound is preferable from the viewpoint enhancing gas barrier properties, resistance to folding, and transparency.

The polysilazane compound is a polymer having a repeating unit containing an -Si-N- bond in a molecule thereof, and specifically, examples thereof include compounds having a repeating unit represented by the formula (1).

[Chemical Formula 1]

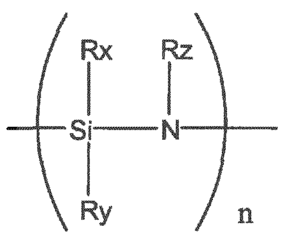

(1)

In the formula (1), n represents an arbitrary natural number; and each of Rx, Ry, and Rz independently represents a hydrogen atom or a non-hydrolyzable group such as an unsubstituted or substituted alkyl group, an unsubstituted or substituted cycloalkyl group, an unsubstituted or substituted alkenyl group, an unsubstituted or substituted aryl group, an alkylsilyl group, etc.

Examples of the alkyl group of the unsubstituted or substituted alkyl group include alkyl groups having a carbon number of from 1 to 10, such as a methyl group, an ethyl group, a n-propyl group, an isopropyl group, a n-butyl group, an isobutyl group, a sec-butyl group, a t-butyl group, a n-pentyl group, an isopentyl group, a neopentyl group, a n-hexyl group, a n-heptyl group, an n-octyl group, etc.

Examples of the cycloalkyl group of the unsubstituted or substituted cycloalkyl group include cycloalkyl groups having a carbon number of from 3 to 10, such as a cyclobutyl group, a cyclopentyl group, a cyclohexyl group, a cycloheptyl group, etc.

Examples of the alkenyl group of the unsubstituted or substituted alkenyl group include alkenyl groups having a carbon number of from 2 to 10, such as a vinyl group, a 1-propenyl group, a 2-propenyl group, a 1-butenyl group, a 2-butenyl group, a 3-butenyl group, etc.

Examples of the substituent of each of the foregoing alkyl group, cycloalkyl group and alkenyl group include halogen atoms such as a fluorine atom, a chlorine atom, a bromine atom, an iodine atom, etc.; a hydroxyl group; a thiol group; an epoxy group; a glycidoxy group; a (meth)acryloyloxy group; unsubstituted or substituted aryl groups such as a phenyl group, a 4-methylphenyl group, a 4-chlorophenyl group, etc.; and the like.

Examples of the aryl group of the unsubstituted or substituted aryl group include aryl groups having a carbon number of from 6 to 10, such as a phenyl group, a 1-naphthyl group, a 2-naphthyl group, etc.

Examples of the substituent of such an aryl group include halogen atoms such as a fluorine atom, a chlorine atom, a bromine atom, an iodine atom, etc.; alkyl groups having a carbon number of from 1 to 6, such as a methyl group, an ethyl group, etc.; alkoxy groups having a carbon number of from 1 to 6, such as a methoxy group, an ethoxy group, etc.; a nitro group; a cyano group; a hydroxyl group; a thiol group; an epoxy group; a glycidoxy group; a (meth)acryloyloxy group; unsubstituted or substituted aryl groups such as a phenyl group, a 4-methylphenyl group, a 4-chlorophenyl group, etc.; and the like.

Examples of the alkylsilyl group include a trimethylsilyl group, a triethylsilyl group, a triisopropylsilyl group, a tri-t-butylsilyl group, a methyldiethylsilyl group, a dimethylsilyl group, a diethylsilyl group, a methylsilyl group, an ethylsilyl group, and the like.

Of these, each of Rx, Ry, and Rz is preferably a hydrogen atom, an alkyl group having a carbon number of from 1 to 6, or a phenyl group, and more preferably a hydrogen atom.

The polysilazane compound having a repeating unit represented by the foregoing formula (1) may be either an inorganic polysilazane in which all of Rx, Ry, and Rz are a hydrogen atom or an organic polysilazane in which at least one of Rx, Ry, and Rz is not a hydrogen atom.

Examples of the inorganic polysilazane include a perhydropolysilazane having a linear structure having a repeating unit represented by the following formula (2), having a molecular weight of from 690 to 2,000, and having from 3 to 10 $SiH_3$ groups in one molecule thereof (see JP-B-1988-16325); a perhydropolysilazane having a linear structure and a branched structure having a repeating unit represented by the following formula (3); a perhydropolysilazane having a perhydropolysilazane structure represented by the following formula (5) and having a linear structure, a branched structure, and a cyclic structure in a molecule thereof; and the like.

[Chemical Formula 2]

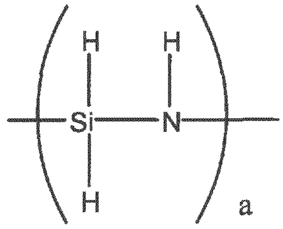

(2)

(In the formula (2), a represents an arbitrary natural number.)

[Chemical Formula 3]

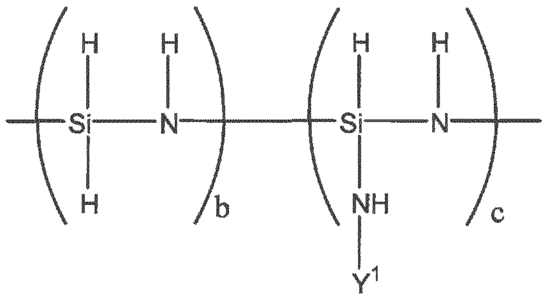

(3)

(In the formula (3), each of b and c represents an arbitrary natural number; and $Y^1$ represents a hydrogen atom or a group represented by the following formula (4).)

[Chemical Formula 4]

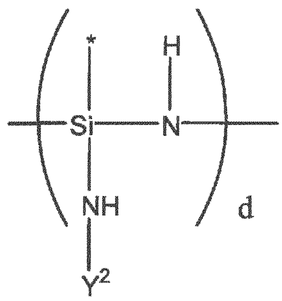

(4)

(In the formula (4), d represents an arbitrary natural number; * represents a bonding position; and $Y^2$ represents a hydrogen atom or a group represented by the formula (4).)

[Chemical Formula 5]

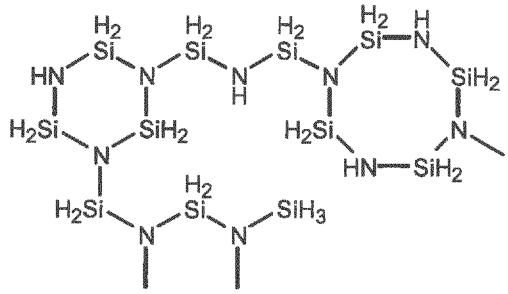

(5)

Examples of the organic polysilazane include compounds of the following formulae (i) to (v); and the like.

(i) A compound having, as a repeating unit, -(Rx'SiHNH)- (Rx' represents an unsubstituted or substituted alkyl group, an unsubstituted or substituted cycloalkyl group, an unsubstituted or substituted alkenyl group, an unsubstituted or substituted aryl group, or an alkylsilyl group; the following Rx's are also the same) and chiefly having a cyclic structure having a degree of polymerization of from 3 to 5.

(ii) A compound having, as a repeating unit, -(Rx'SiHNRz')- (Rz' represents an unsubstituted or substituted alkyl group, an unsubstituted or substituted cycloalkyl group, an unsubstituted or substituted alkenyl group, an unsubstituted or substituted aryl group, or an alkylsilyl group) and chiefly having a cyclic structure having a degree of polymerization of from 3 to 5.

(iii) A compound having, as a repeating unit, -(Rx'Ry'SiNH)- (Ry' represents an unsubstituted or substituted alkyl group, an unsubstituted or substituted cycloalkyl group, an unsubstituted or substituted alkenyl group, an unsubstituted or substituted aryl group, or an alkylsilyl group) and chiefly having a cyclic structure having a degree of polymerization of from 3 to 5.

(iv) A polyorgano(hydro)silazane having a structure represented by the following formula (6) in a molecule thereof.

(v) A polysilazane having a repeating structure represented by the following formula (7).

[Chemical Formula 6]

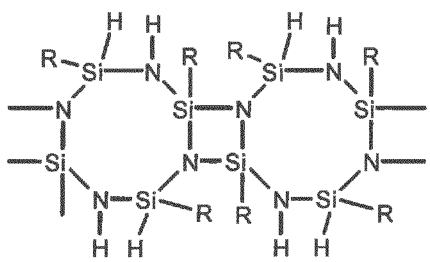

(6)

R=$CH_3$

[Chemical Formula 7]

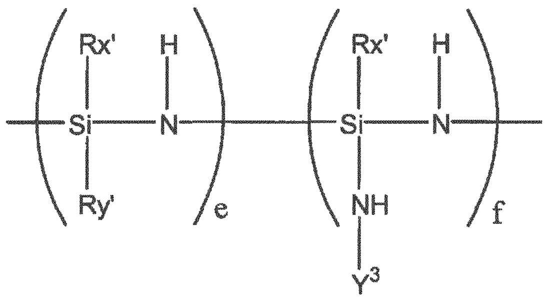

(7)

(In the formula (7), Rx' and Ry' have the same meanings as those described above; each of e and f represents an arbitrary natural number; and $Y^3$ represents a hydrogen atom or a group represented by the following formula (8).)

[Chemical Formula 8]

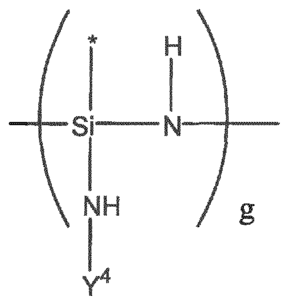

(8)

(In the formula (8), g represents an arbitrary natural number; * represents a bonding position; and $Y^4$ represents a hydrogen atom or a group represented by the formula (8).)

The foregoing organic polysilazane can be manufactured by a conventionally known method.

As a specific manufacturing method, for example, the organic polysilazane can be synthesized by allowing a reaction product of an unsubstituted or substituted halogenosilane compound represented by the following formula (9) with a secondary amine to react with ammonia or a primary amine. The secondary amine and the primary amine which are used may be properly chosen depending upon the structure of the desired polysilazane compound.

[Chemical Formula 9]

$$R^1_{4-m}\ Si\ X_m \qquad (9)$$

(In the formula (9), m represents 2 or 3; X represents a halogen atom; and $R^1$ represents any one of the foregoing substituents Rx, Ry, Rz, Rx', Ry', and Rz'.

In addition, in the present invention, a polysilazane modified product can also be used as the polysilazane compound. Examples of the polysilazane modified product include a polymetallosilazane containing a metal atom (the metal atom may be crosslinked); a polysiloxazane having, as repeating units, $[(SiH_2)_g(NH)_h]$ and $[(SiH_2)_iO]$ (in the formulae, each of g, h, and i independently represents 1, 2, or 3) (JP-A-1987-195024); a polyborosilazane manufactured by allowing a polysilazane to react with a boron compound (JP-A-1990-84437); a polymetallosilazane manufactured by allowing a polysilazane and a metal alkoxide to react with each other (JP-A-1988-81122, etc.); an inorganic silazane high polymer or a modified polysilazane (JP-A-1989-138108, etc.); a copolysilazane in which an organic component is introduced into a polysilazane (JP-A-1990-175726, etc.); a low-temperature ceramized polysilazane in which a catalytic compound for promoting ceramization is added or loaded to a polysilazane (JP-A-1993-238827, etc.); a silicon alkoxide-added polysilazane (JP-A-1993-238827); a glycidol-added polysilazane (JP-A-1994-122852); an acetylacetonate complex-added polysilazane (JP-A-1994-306329); a metal carboxylate-added polysilazane (JP-A-1994-299118, etc.); a polysilazane composition in which an amine and/or an acid is loaded to such a polysilazane or a modified product thereof (JP-A-1997-31333); a modified polysilazane obtained by adding an alcohol such as methanol, etc. to a perhydropolysilazane or adding hexamethyldisilazane to a terminal N atom (JP-A-1993-345826 and JP-A-1992-63833); and the like.

Of these, the polysilazane compound is preferably an inorganic polysilazane in which all of Rx, Ry, and Rz are a hydrogen atom or an organic polysilazane in which at least one of Rx, Ry, and Rz is not a hydrogen atom, and from the viewpoints of easiness of availability and the fact that a layer with excellent gas barrier properties can be formed, it is more preferably an inorganic polysilazane, and still more preferably a perhydropolysilazane.

Though a number average molecular weight of the polysilazane compound which is used is not particularly limited, it is preferably from 100 to 50,000. Incidentally, in the present invention, the number average molecular weight (Mn) is a value calculated as a reduced value into polystyrene by the gel permeation chromatography (GPC method) (hereinafter the same).

Furthermore, in the present invention, as for the polysilazane compound, commercially available products which are put on the market as a glass coating material or the like can be used as they are.

In addition, the gas barrier layer may contain, in addition to the polysilazane compound, other components within the range where the object of the present invention is not impaired. Examples of other components include a curing agent, other polymer, an anti-aging agent, a light stabilizer, a flame retarder, and the like.

From the viewpoint of forming a gas barrier layer with excellent gas barrier properties, a content of the polysilazane compound in the gas barrier layer is preferably 50 % by mass or more, more preferably 70 % by mass or more, still more preferably 85 % by mass or more, and yet still more preferably substantially 100 % by mass in the whole of the materials constituting the gas barrier layer.

A method for forming the gas barrier layer is not particularly restricted, and for example, there is exemplified a method for forming the gas barrier layer by applying a gas barrier layer forming solution containing at least one polysilazane compound and if desired, other components, and a solvent and the like on the foregoing base material and appropriately drying the obtained coating film. A coating method is not particularly limited, and there is exemplified a method of using a known coating apparatus such as a spin coater, a knife coater, a gravure coater, etc. In addition, for the purposes of drying the obtained coating film and enhancing the gas barrier properties of the gas barrier layer, it is preferable to heat the coating film. The heating is performed preferably at from 80 to 150°C for from several ten seconds to several ten minutes, more preferably at from 80 to 150°C for from 10 seconds to 120 minutes, still more preferably at from 95 to 140°C for from 30 seconds to 40 minutes, and yet still more preferably at from 95 to 140°C for from 60 seconds to 30 minutes.

Furthermore, the gas barrier layer can also be formed by bringing a gas of a plasma polymerizable silazane compound such as dimethyldisilazane, tetramethyldisilazane, hexamethyldisilazane, etc. into contact with a base material, followed by applying a plasma polymerization treatment (JP-A-1997-143289).

A thickness of the gas barrier layer formed is preferably from 20 nm to 100 μm, more preferably from 30 to 500 nm, and still more preferably from 40 to 200 nm. Incidentally, in the present invention, even when the gas barrier layer is in a nano- order scale, an adhesive sheet having a sufficient gas barrier performance can be obtained.

<Requirement (b)>

The surface layer part of the gas barrier layer in the present invention refers to a surface of the gas barrier layer and a region extending from the subject surface to a depth of 5 nm in the thickness direction. In addition, in the case where the gas barrier layer forms a boundary surface with other layer, the surface of the gas barrier layer also includes the subject boundary surface.

Existing proportions of an oxygen atom, a nitrogen atom, and a silicon atom in the surface layer part of the gas barrier layer can be confirmed by performing the elemental analysis measurement of the surface layer part of the gas barrier layer in the vicinity of 5 nm from the surface by adopting the X-ray photoelectron spectroscopic analysis (XPS). Specifically, the measurement is performed by the method described in the Examples.

In the surface layer part of the gas barrier layer according to the present invention, the existing proportion of the oxygen atom is from 60 to 75 %, the existing proportion of a nitrogen atom is from 0 to 10 %, and the existing proportion of a silicon atom is from 25 to 35 %; and preferably, the existing proportion of the oxygen atom is from 60 to 72 %, the existing proportion of a nitrogen atom is from 0.1 to 8.0 %, and the existing proportion of a silicon atom is from 27 to 35 %, relative to a total existing amount of the oxygen atom, the nitrogen atom, and the silicon atom.

<Requirement (c)>

From the viewpoint of enhancing the gas barrier properties, resistance to folding, and transparency, though a film density in the surface layer part of the gas barrier layer according to the present invention is from 2.4 to 4.0 g/cm$^3$, it is preferably from 2.45 to 4.0 g/cm$^3$, and more preferably from 2.5 to 4.0 g/cm$^3$.

When the subject film density is less than 2.4 g/cm$^3$, in particular, inferiority in the gas barrier properties of the adhesive sheet is resulted.

The film density can be calculated by adopting the X-ray reflectometry (XRR). When X-rays are made incident into a thin film on a substrate at a very low angle, they are subjected to total reflection. When the angle of the incident X-rays is a critical total reflection angle or more, the X-rays penetrate into the inside of the thin film and are divided into a transmitted wave and a reflected wave on the thin film surface or interface, and the reflected wave causes an interference. By analyzing the critical total reflection angle, the density of the film can be determined. Incidentally, a film thickness of the thin film can also be determined by performing the measurement while changing the angle of incidence and analyzing interference signals of the reflected wave following a change of the optical path difference.

The film density can be measured in the following method.

In general, it is known that a refractive index n of a substance to X-rays and δ of a real part of the refractive index n are those expressed by the following Equations 1 and 2.

[Equation 1]

$$n = 1 - \delta - i\beta \cdots \text{(Equation 1)}$$

[Equation 2]

$$\delta = \left(\frac{r_e \lambda^2}{2\pi}\right) N_0 \rho \sum_i x_i \left(Z_i + f_i'\right) / \sum_i x_i M_i \quad \cdots \text{(Equation 2)}$$

Here, $r_e$ represents a classical radius ($2.818 \times 10^{-15}$ m) of an electron; $N_0$ represents the Avogadro number; $\lambda$ represents a wavelength of the X-rays; $\rho$ represents a density (g/cm$^3$); $Z_i$, $M_i$, and $x_1$ represents an atomic number, an atomic weight, and an atomic number ratio (molar ratio) of the i-th atom, respectively; and $f_i$' represents an atomic scattering factor (anomalous dispersion term) of the i-th atom. In addition, when $\beta$ related to the absorption is ignored, a critical total reflection angle $\theta_c$ is given by Equation 3; and from the relation between the Equations 2 and 3, the density $\rho$ can be determined by Equation 4.

[Equation 3]

$$\theta_c = \sqrt{2\delta} \quad \cdots \text{(Equation 3)}$$

[Equation 4]

$$\rho = \frac{\theta_c^2 \sum_i x_i M_i}{\left(\frac{r_e \lambda^2}{\pi}\right) N_0 \sum_i x_i \left(Z_i + f_i'\right)} \quad \cdots \text{(Equation 4)}$$

Here, $\theta_c$ is a value which can be determined from an X-ray reflectance; each of $r_e$, $N_0$, and $\lambda$ is a constant; and each of $Z_i$, $M_i$, and $f_i$' is a value inherent to each constituent atom. Incidentally, as for the atomic number ratio (molar ratio) $x_i$, a result obtained by the XPS measurement is adopted.

The film density in the surface layer part of the gas barrier layer is obtained by measuring with a method described in Examples and calculating using Equation 4.

It is preferable that the gas barrier layer according to the present invention is adjusted so as to satisfy the foregoing requirements (b) and (c) by implanting an ion. Accordingly, it is preferable that the gas barrier layer of the adhesive sheet according to the present invention is formed by implanting an ion.

Though a timing of implanting an ion is not particularly limited, for example, there are exemplified procedures in which after forming a gas barrier layer on a base material, an ion is implanted into the gas barrier layer.

Examples of the ion which is implanted include ions formed by ionizing a rare gas of argon, helium, neon, krypton, xenon, etc.; ions formed by ionizing a gas of a fluorocarbon, hydrogen, nitrogen, oxygen, carbon dioxide, chlorine, fluorine, sulfur, etc.; metal ions of gold, silver, copper, platinum, nickel, palladium, chromium, titanium, molybdenum, niobium, tantalum, tungsten, aluminum, etc.; and the like.

Of these, from the viewpoints of achieving the implantation more simply and easily and obtaining an adhesive sheet with especially excellent gas barrier properties and transparency, the ion is preferably an ion formed by ionizing at least one gas selected from the group consisting of hydrogen, nitrogen, oxygen, argon, helium, neon, xenon, and krypton.

Incidentally, an implantation amount of the ion is properly determined while taking into consideration the use purpose of the adhesive sheet (necessary gas barrier properties and transparency, and the like) or the like. As a condition for implanting an ion, a known condition can be adopted, and examples thereof include the condition described in the Examples, and the like.

Examples of a method for implanting an ion include a method for irradiating an ion (ion beam) accelerated by an electric field, a method for implanting an ion in plasma (plasma ion implantation method), and the like. Of these, from the viewpoint of obtaining an adhesive sheet with excellent gas barrier properties, etc. simply and easily, a plasma ion implantation method is preferable.

The plasma ion implantation method can be, for example, performed by generating plasma under an atmosphere containing a plasma generating gas and impressing a negative high-voltage pulse to the gas barrier layer, thereby implanting an ion (cation) in the plasma into the surface part of the gas barrier layer.

A thickness of a portion into which an ion is implanted can be controlled by an implantation condition such as the kind of the ion, an impressed voltage, a treatment time, etc., and may be determined depending upon the thickness of the gas barrier layer, the use purpose of the adhesive sheet or the like.

The thickness of the portion into which an ion is implanted is preferably from 10 to 1,000 nm, more preferably from 10 to 500 nm, and still more preferably from 10 to 250 nm.

[(3) Adhesive layer]

The adhesive forming the adhesive layer is a rubber based adhesive containing a polyisobutylene based resin, and preferably an adhesive containing a polyisobutylene based resin and a polybutene resin.

The polyisobutylene based resin is a resin having a polyisobutylene skeleton in a main chain or side chain thereof and is a resin having the following constituent unit (a). Examples thereof include polyisobutylene that is a homopolymer of isobutylene; a copolymer of isobutylene and isoprene, isobutylene and n-butene, or isobutylene and butadiene; a halogenated butyl rubber obtained by brominating or chlorinating such a copolymer; and the like. Incidentally, in the case where the polyisobutylene based resin is a copolymer obtained from isobutylene and n-butene, the isobutylene is a monomer of the maximum amount as a main component in the raw material monomers. The polyisobutylene based resin may be used solely or in combination of two or more kinds thereof.

[Chemical Formula 10]

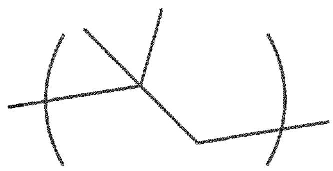

··· (a)

A weight average molecular weight of the polyisobutylene based resin is preferably from 200,000 to 1,000,000, more preferably from 250,000 to 800,000, and still more preferably from 300,000 to 500,000. When the weight average molecular weight of the polyisobutylene based resin is 200,000 or more, a sufficient cohesive power of the adhesive composition can be obtained. In addition, when it is not more than 1,000,000, the cohesive power of the adhesive composition does not become excessively high, wetting with an adherend is sufficiently obtained, and at the time of preparing an adhesive, it can be sufficiently dissolved in a solvent. In consequence, by choosing an adequate molecular weight, a low water vapor transmission rate, a high cohesive power, wetting properties, and the like can be kept. Incidentally, this weight average molecular weight (Mw) is a value calculated as a reduced value into polystyrene which is measured by the gel permeation chromatography (GPC) (hereinafter the same).

The polybutene resin is a copolymerized substance having a molecular structure of a long-chain hydrocarbon, and examples thereof include a polybutene copolymer, an ethylene-1-butene copolymer elastomer, an ethylene-propylene-1-butene copolymer elastomer, a propylene-1-butene copolymer elastomer, an ethylene-1-butene-non-conjugated diene copolymer elastomer, an ethylene propylene rubber such as an ethylene-propylene-1-butene-non-conjugated diene copolymer elastomer, etc., and the like. Of these, a polybutene copolymer is preferably. The polybutene copolymer is a copolymer obtained by copolymerizing isobutene, 1-butene, or 2-butene, and of these, an isobutene-1-butene copolymer is preferable.

The polybutene resin may be used solely or in combination of two or more kinds thereof. This polybutene resin is a resin which is well compatible with the foregoing polyisobutylene based resin and adequately plasticizes this polyisobutylene based resin to increase wetting properties against an adherend, thereby enhancing physical properties of adhesives, flexibility, holding power, and the like.

A weight average molecular weight of the polybutene resin is preferably from 500 to 100,000, more preferably from 1,000 to 50,000, and still more preferably from 3,000 to 10,000. When the weight average molecular weight of the polybutene resin is 500 or more, it is possible to prevent a concern of adversely affecting physical properties, such as contamination of an adherend to be caused due to separation as a low-molecular component, an increase of an outgas generated at high temperatures, etc. In addition, when it is not more than 100,000, it is possible to obtain a sufficient plasticizing effect, and wetting with an adherend is sufficient. The foregoing weight average molecular weight is a value as reduced into polystyrene which is measured by the gel permeation chromatography (GPC).

A content of the polybutene resin is preferably from 10 to 100 parts by mass, more preferably from 15 to 100 parts by mass, and still more preferably from 25 to 100 parts by mass based on 100 parts by mass of the polyisobutylene based resin.

By incorporating the polyisobutylene based resin and the polybutene resin each having a specified weight average molecular weight in specified amounts, an adhesive composition capable of forming an adhesive layer which is well balanced between the adhesive force or cohesive power and the water vapor transmission rate and which is

excellent in the transparency is obtained.

In the adhesive composition which is used in the present invention, from the viewpoints of enhancing a light stabilizer performance and enhancing durability of the adhesive layer, a hindered amine based light stabilizer as a light stabilizer, or a hindered phenol based antioxidant as an antioxidant may be contained. Each of the hindered amine based light stabilizer and the hindered phenol based antioxidant may be used solely or in combination of two or more kinds thereof.

Specifically, examples of the hindered amine based light stabilizer include a dimethyl succinate-1-(2-hydroxyethyl)-4-hydroxy-2,2,6,6-tetramethylpiperidine polycondensate, poly[{6-(1,1,3,3-tetramethylbutyl)amino-1,3,5-triazine-2,4-diyl}{(2,2,6,6-tetramethyl-4-piperidyl)imino}hexamethylene{(2,2,6,6-tetramethyl-4-piperidyl)imino}], poly[{6-morpholino-s-triazine-2,4-diyl}{(2,2,6,6-tetramethyl-4-piperidyl)imino}hexamethylene{(2,2,6,6-tetramethyl-4-piperidyl)imino}], N,N',N",N"'-tetrakis-(4,6-bis-(butyl-(N-methyl-2,2,6,6-tetramethylpiperidin-4-yl)-4,7-diazadecane-1,10-diamine, bis(1,2,2,6,6-pentamethyl-4-piperidyl)[[3,5-bis(1,1-dimethylethyl)-4-hydroxyphenyl]methyl]butyl malonate, a reaction product of a reaction product of cyclohexane with N-butyl-2,2,6,6-tetramethyl-4-piperidineamine-2,4,6-trichloro-1,3,5-triazine peroxide with 2-aminoethanol, decane diacid bis(2,2,6,6-tetramethyl-1-(octyloxy)-4-piperidinyl) ester, a reaction product of 1,1-dimethylethylhydroperoxide with octane, bis(1,2,2,6,6-pentamethyl-piperidyl)sebacate and methyl 1,2,2,6,6-pentamethyl-4-piperidylsebacate (mixture), N,N',N",N"'-tetrakis-(4,6-bis-(butyl-(N-methyl-2,2,6,6-tetramethylpiperidin-4-yl)-4,7-diazadecane-1,10-diamine, bis(1,2,2,6,6-pentamethyl-piperidyl)sebacate and methyl 1,2,2,6,6-pentamethyl-4-piperidylsebacate (mixture), bis(2,2,6,6-tetramethyl-4-piperidyl)sebacate, 1-{2-[3-(3,5-di-t-butyl-4-hydroxyphenyl)propionyloxy]ethyl}-4-[3-(3,5-di-t-butyl-4-hydroxyphenyl)propionyloxy]-2,2,6,6-tetramethylpyridine, 4-benzoyloxy-2,2,2,6-tetramethylpiperidine, and the like.

Specifically, examples of the hindered phenol based antioxidant include triethylene glycol-bis[3-(3-t-butyl-5-methyl-4-hydroxyphenyl)propionate], 1,6-hexanediol-bis[3-(3,5-di-t-butyl-4-hydroxyphenyl)propionate], pentaerythrityl·tetrakis[3-(3,5-di-t-butyl-4-hydroxyphenyl)propionate], 2,2-thio-diethylenebis[3-(3,5-di-t-butyl-4-hydroxyphenyl)propionate], octadecyl-3-(3,5-di-t-butyl-4-hydroxyphenyl)propionate, N,N'-hexamethylenebis(3,5-di-t-butyl-4-hydroxy-hydrocinnamide), 1,3,5-trimethyl-2,4,6-tris(3,5-di-t-butyl-4-hydroxybenzyl)benzene, tris-(3,5-di-t-butyl-4-hydroxybenzyl)-isocyanurate, 2,4-bis-(n-octylthio)-6-(4-hydroxy-3,5-di-t-butylanilino)-1,3,5-triazine, 2,4-bis[(octylthio)methyl]-o-cresol, 2,6-di-t-butyl-p-cresol, 4,4'-butylidenebis-(6-t-butyl-3-methylphenol), 2,2'-methylenebis-(4-methyl-6-t-butylphenol), 2,2'-methylenebis-(4-ethyl-6-t-butylphenol), 2,6-di-t-butyl-4-ethylphenol, 1,1,3-tris(2-methyl-4-hydroxy-5-t-butylphenyl)butane, 1,3,5-tris(3,5-di-t-butyl-4-hydroxybenzyl)-1,3,5-triazine-2,4,6(1H,3H,5H)trione, isooctyl (3,5-di-t-butyl-4-hydroxyphenyl)propionate, 1,6-hexanediol-bis[3-(3,5-di-t-butyl-4-hydroxyphenyl)propionate], pentaerythrityl·tetrakis[3-(3,5-di-t-butyl-4-hydroxyphenyl)propionate], 2,2-thio-diethylenebis[3-(3,5-di-t-butyl-4-hydroxyphenyl)propionate], octadecyl-3-(3,5-di-t-butyl-4-hydroxyphenyl)propionate, N,N'-hexamethylenebis(3,5-di-t-butyl-4-hydroxy-hydrocinnamide), 1,3,5-trimethyl-2,4,6-tris(3,5-di-t-butyl-4-hydroxybenzyl)benzene, tris-(3,5-di-t-butyl-4-hydroxybenzyl)-isocyanurate, 2,4-bis-(n-octylthio)-6-(4-hydroxy-3,5-di-t-butylanilino)-1,3,5-triazine, 2,6-di-t-butyl-p-cresol, 2,6-di-t-butyl-4-ethylphenol, 1,3,5-tris(3,5-di-t-butyl-4-hydroxybenzyl)-1,3,5-triazine-2,4,6(1H,3H,5H)trione, isooctyl (3,5-di-t-butyl-4-hydroxyphenyl)propionate, 2-t-butyl-6-(3-t-butyl-2-hydroxy-5-methylbenzyl)-4-methylphenyl acrylate, 2-[1-(2-hydroxy-3,5-di-t-pentylphenyl)ethyl]-4,6,-di-t-pentylphenyl acrylate, N,N'-hexamethylenebis(3,5-di-t-butyl-4-hydroxy-hydrocinnamide), 3,9-bis[2-[3-(3-t-butyl-4-hydroxy-5-methylphenyl)propionyloxy]-1,1-dimethylethyl]-2,4,8,10-tetraoxaspiro[5,5]undecane, 4,4'-thiobis(6-t-butyl-3-methylphenol), 6-[3-(3-t-butyl-4-hydroxy-5-methylphenyl)propoxy]-2,4,8,10-tetra-t-butyldibenz[d,f][1,3,2]dioxaphosphepin, and the like.

A content of the hindered amine based light stabilizer is preferably from 0.25 to 1.0 part by mass, and more preferably from 0.4 to 1.0 part by mass based on 100 parts by mass of the polyisobutylene based resin.

In addition, a content of the hindered phenol based antioxidant is preferably from 0.25 to 1.0 part by mass, and more preferably from 0.4 to 1.0 part by mass based on 100 parts by mass of the polyisobutylene based resin.

In addition, in the adhesive composition which is used in the present invention, a cyclic olefin based polymer may be further contained. The cyclic olefin based polymer is useful for purposes such as adjustment of a viscosity at the time of coating, an enhancement of flexibility due to a plasticizing effect, an enhancement of an initial adhesive force due to an enhancement of wetting properties, an increase of a cohesive power, etc. In addition, the cyclic olefin based polymer is also preferable in view of a low water vapor transmission rate.

In the present invention, the cyclic olefin based polymer means a polymer containing a repeating unit originated from a cyclic olefin based monomer. A bonding mode of the cyclic olefin based monomer is not particularly limited so far as it is a mode in which a cyclic structure may be introduced into a main chain thereof.

Examples of the cyclic olefin based polymer include polymers obtained by polymerizing a carbon-carbon unsaturated bond of the subject monomer; polymers obtained by addition polymerization of a cyclic conjugated diene; and the like. More specifically, examples thereof include polymers obtained by addition polymerization of a norbornene ring-containing alicyclic monomer; polymers obtained by copolymerization with a copolymerizable monomer other than cyclic olefins; ring-opened polymers obtained by ring-opening polymerization of a norbornene ring-containing alicyclic monomer; polymers obtained by addition polymerization of a monocyclic cyclic olefin based monomer; polymers obtained by

1,4-addition polymerization of a cyclic conjugated diene based monomer such as cyclopentadiene, cyclohexadiene, etc.; polymers obtained by copolymerization of a monocyclic cyclic olefin based monomer, a cyclic conjugated diene based monomer, and a copolymerizable monomer other than cyclic olefins; and the like.

In addition, polymers having been further hydrogenated may be used as such a polymer. Specifically, there can be exemplified so-called hydrogenated petroleum resins obtained by hydrogenation of a petroleum resin which is known as a tackifier; and the like.

As the hydrogenated petroleum resin, there can be exemplified a partially hydrogenated resin with a different hydrogenation rate and a completely hydrogenated resin. From the standpoints of compatibility with the foregoing polyisobutylene resin and the foregoing polybutene resin, water vapor transmission rate, and durability against high humidity and temperature and ultraviolet rays, a completely hydrogenated resin is preferable.

Incidentally, such a cyclic olefin based polymer may be used solely or in combination of two or more kinds thereof.

From the viewpoints of adhesiveness, wetting with an adherend, and compatibility with the polyisobutylene based resin, a weight average molecular weight of the cyclic olefin based polymer is preferably from 200 to 5,000, and more preferably from 500 to 3,000.

From the viewpoints of adhesiveness and wetting with an adherend, a content of the cyclic olefin based polymer is preferably from 10 to 300 parts by mass, and more preferably from 10 to 100 parts by mass based on 100 parts by mass of the polyisobutylene based resin.

Furthermore, the adhesive according to the present invention may further contain, as other additives, a light stabilizer, an antioxidant, an ultraviolet light absorber, a resin stabilizer, a filler, a pigment, an extender, an antistatic agent, a tackifier, or the like within the range where the adhesiveness and the like are not impaired. Such an additive may be used solely or in combination of two or more kinds thereof.

Though a thickness of the foregoing adhesive layer is not particularly limited and is properly chosen depending upon an application of the adhesive sheet, or the like, it is preferably from 0.5 to 100 μm, more preferably from 1 to 60 μm, and still more preferably from 3 to 40 μm. When the thickness of the foregoing adhesive layer is 0.5 μm or more, a favorable adhesive force against an adhered is obtained, whereas when it is not more than 100 μm, an adhesive sheet which is advantageous in view of productivity and is easy for handling may be formed.

A method for forming the adhesive layer according to the present invention is not particularly limited, and the adhesive layer according to the present invention can be manufactured by a known method. For example, the adhesive layer can be manufactured by dissolving the adhesive composition in an organic solvent such as toluene, ethyl acetate, methyl ethyl ketone, etc. to prepare a solution and then applying the solution using a known coating method. In that case, a concentration of the subject solution is preferably from 10 to 60 % by mass, and more preferably from 10 to 30 % by mass.

Examples of the coating method include methods such as a spin coating method, a spray coating method, a bar coating method, a knife coating method, a roll coating method, a blade coating method, a die coating method, a gravure coating method, etc. According to such a coating method, the adhesive layer can be formed by heating for drying at a temperature of from 80 to 150°C for from 30 seconds to 5 minutes for the purpose of preventing retention of the solvent or low-boiling point component after applying the solution having the foregoing adhesive dissolved in an organic solvent on a base material or a release layer surface of a release sheet.

In the adhesive sheet according to the present invention, a release sheet may further be provided on the formed adhesive layer, if desired. In the adhesive sheet according to the present invention, an adhesive sheet in which a release sheet is laminated on the adhesive layer is preferable in view of convenience at the time of conveyance or at the time of use.

The adhesive sheet according to the present invention may take a form in which the release sheet is located in an outermost layer of the layers constituting the adhesive sheet, or may take a form in which the release sheet which is allowed to have release properties on the both surfaces thereof is laminated on the formed adhesive layer and then wound up as it is.

Examples of this release sheet include release sheets obtained by applying a release agent on a paper base material such as glassine paper, coated paper, wood-free paper, etc., a laminated paper obtained by laminating a thermoplastic resin such as polyethylene, polypropylene, etc. on such a paper base material, a paper base material obtained by subjecting the foregoing base material to a filling treatment with cellulose, starch, polyvinyl alcohol, an acrylic-styrene resin, or the like, a plastic film such as a polyester film, e.g., polyethylene terephthalate, polybutylene terephthalate, polyethylene naphthalate, etc., and a polyolefin film, e.g., polyethylene, polypropylene, etc., a film obtained by subjecting such a plastic film to an easy adhesion treatment, or the like, thereby forming a release agent layer; and the like.

Examples of the release agent include rubber based elastomers such as olefin based resins, isoprene based resins, butadiene based resins, etc., long-chain alkyl based resins, alkyd based resins, fluorine based resins, silicone based resins, and the like.

Though a thickness of the release agent layer which is formed on the base material of the release sheet is not particularly limited, in the case of applying the solution fabricated by dissolving the release agent in the foregoing organic

solvent on the base material, it is preferably from 0.05 to 2.0 μm, and more preferably from 0.1 to 1.5 μm. On the other hand, in the case of forming the release agent layer using a thermoplastic resin such as polyethylene, polypropylene, etc., the thickness of the release agent layer is preferably from 3 to 50 μm, and more preferably from 5 to 40 μm.

A water vapor transmission rate of the adhesive layer of the adhesive sheet according to the present invention at a thickness of 50 μm is preferably not more than 25 $g/m^2$/day, more preferably not more than 10 $g/m^2$/day, and still more preferably not more than 8 $g/m^2$/day under an atmosphere at 40°C and a relative humidity of 90 %. When the water vapor transmission rate is not more than 25 $g/m^2$/day, since the penetration of water from an end of the adhesive layer can be prevented, the adhesive sheet according to the present invention can also be suitably used for encapsulation of an organic EL element.

In addition, as for an adhesive force of the adhesive sheet according to the present invention, even in the case where the thickness of the adhesive layer is small, a high adhesive force is attained. The adhesive force of the adhesive sheet according to the present invention is preferably 3 N/25 mm or more, and more preferably 5 N/25 mm or more. Incidentally, the adhesive force of the adhesive sheet according to the present invention means a value measured by the method described in the Examples.

[(4) Other layer]

The adhesive sheet according to the present invention can be provided with other layer than the foregoing (1) to (3). Examples of the other layer include an inorganic compound layer, an impact absorption layer, a conductor layer, a primer layer, and the like. Incidentally, a position at which the other layer is laminated is not particularly limited, and it is properly chosen depending upon a role of each layer.

(Inorganic compound layer)

The inorganic compound layer is a layer composed of one or two or more inorganic compounds and is able to more enhance the gas barrier properties of the adhesive sheet. Examples of the inorganic compound constituting the inorganic compound layer include inorganic compounds capable of being in general subjected to vacuum film formation and having gas barrier properties, for example, inorganic oxides, inorganic nitrides, inorganic carbides, inorganic sulfides, and complexes thereof including inorganic oxynitrides, inorganic oxycarbides, inorganic carbonitrides, and inorganic oxycarbonitrides, and the like. In the present invention, of these, inorganic oxides, inorganic nitrides, and inorganic oxynitrides are preferable.

Examples of the inorganic oxide include metal oxides represented by the general formula: $MO_x$.

In the formula, M represents a metal element. The range of x varies with M. For example, when M is silicon (Si), then x is a value ranging from 0.1 to 2.0; when M is aluminum (Al), then x is a value ranging from 0.1 to 1.5; when M is magnesium (Mg), then x is a value ranging from 0.1 to 1.0; when M is calcium (Ca), then x is a value ranging from 0.1 to 1.0; when M is potassium (K), then x is a value ranging from 0.1 to 0.5; when M is tin (Sn), then x is a value ranging from 0.1 to 2.0; when M is sodium (Na), then x is a value ranging from 0.1 to 0.5; when M is boron (B), then x is a value ranging from 0.1 to 1.5; when M is titanium (Ti), then x is a value ranging from 0.1 to 2.0; when M is lead (Pb), then x is a value ranging from 0.1 to 1.0; when M is zirconium (Zr), then x is a value ranging from 0.1 to 2.0; and when M is yttrium (Y), then x is a value ranging from 0.1 to 1.5.

Of these, from the viewpoint of forming a layer with excellent transparency or the like, silicon oxides in which M is silicon, aluminum oxides in which M is aluminum, and titanium oxides in which M is titanium are preferable, with silicon oxides being more preferable. Incidentally, from the viewpoint of forming a layer with excellent transparency or the like, when M is silicon, then the value of x is preferably in the range of from 1.0 to 2.0; when M is aluminum, then the value of x is preferably in the range of from 0.5 to 1.5; and when M is titanium, then the value of x is preferably in the range of from 1.3 to 2.0.

Examples of the inorganic nitride include metal nitrides represented by the general formula: $MN_y$.

In the formula, M represents a metal element. The range of y varies with M. When M is silicon (Si), then y is a value ranging from 0.1 to 1.3; when M is aluminum (Al), then y is a value ranging from 0.1 to 1.1; when M is titanium (Ti), then y is a value ranging from 0.1 to 1.3; and when M is tin (Sn), then y is a value ranging from 0.1 to 1.3.

Of these, from the viewpoint of forming a layer with excellent transparency or the like, silicon nitrides in which M is silicon, aluminum nitrides in which M is aluminum, titanium nitrides in which M is titanium, and tin nitrides in which M is tin are preferable, and silicon nitride (SiN) is more preferable. Incidentally, from the viewpoint of forming a layer with excellent transparency or the like, when M is silicon, then the value of y is preferably in the range of from 0.5 to 1.3; when M is aluminum, then the value of y is preferably in the range of from 0.3 to 1.0; when M is titanium, then the value of y is preferably in the range of from 0.5 to 1.3; and when M is tin, then the value of y is preferably in the range of from 0.5 to 1.3.

Examples of the inorganic oxynitride include metal oxynitrides represented by the general formula: $MO_xN_y$.

In the formula, M represents a metal element. The range of each of x and y varies with M. That is, for example, when M is silicon (Si), then x is a value ranging from 0.1 to 2.0, and y is a value ranging from 0.1 to 1.3; when M is aluminum (Al), then x is a value ranging from 0.5 to 1.0, and y is a value ranging from 0.1 to 1.0; when M is magnesium (Mg), then x is a value ranging from 0.1 to 1.0, and y is a value ranging from 0.1 to 0.6; when M is calcium (Ca), then x is a value ranging from 0.1 to 1.0, and y is a value ranging from 0.1 to 0.5; when M is potassium (K), then x is a value ranging from 0.1 to 0.5, and y is a value ranging from 0.1 to 0.2; when M is tin (Sn), then x is a value ranging from 0.1 to 2.0, and y is a value ranging from 0.1 to 1.3; when M is sodium (Na), then x is a value ranging from 0.1 to 0.5, and y is a value ranging from 0.1 to 0.2; when M is boron (B), then x is a value ranging from 0.1 to 1.0, and y is a value ranging from 0.1 to 0.5; when M is titanium (Ti), then x is a value ranging from 0.1 to 2.0, and y is a value ranging from 0.1 to 1.3; when M is lead (Pb), then x is a value ranging from 0.1 to 1.0, and y is a value ranging from 0.1 to 0.5; when M is zirconium (Zr), then x is a value ranging from 0.1 to 2.0, and y is a value ranging from 0.1 to 1.0; and when M is yttrium (Y), then x is a value ranging from 0.1 to 1.5, and y is a value ranging from 0.1 to 1.0.

Of these, from the viewpoint of forming a layer with excellent transparency or the like, silicon oxynitrides in which M is silicon, aluminum oxynitrides in which M is aluminum, and titanium oxynitrides in which M is titanium are preferable, with silicon oxynitrides being more preferable. Incidentally, from the viewpoint of forming a layer with excellent transparency or the like, when M is silicon, then the value of x is preferably in the range of from 1.0 to 2.0, and the value of y is preferably in the range of from 0.1 to 1.3; when M is aluminum, then the value of x is preferably in the range of from 0.5 to 1.0, and the value of y is preferably in the range of from 0.1 to 1.0; and when M is titanium, then the value of x is preferably in the range of from 1.0 to 2.0, and the value of y is preferably in the range of from 0.1 to 1.3.

Incidentally, in the metal oxides, the metal nitrides, and the metal oxynitrides, two or more metals may be contained.

A method for forming the inorganic compound layer is not particularly limited, and examples thereof include a vapor deposition method, a sputtering method, an ion plating method, a thermal CVD method, a plasma CVD method, a dynamic ion mixing method, and the like. Above all, in the present invention, in view of the fact that a laminate with excellent gas barrier properties is obtained simply and easily, a magnetron sputtering method is preferable.

Though a thickness of the inorganic compound layer is not particularly limited, from the viewpoint of enhancing the gas barrier properties, it is preferably from 10 to 1,000 nm, more preferably from 20 to 500 nm, and still more preferably from 50 to 200 nm.

(Impact absorption layer)

The impact absorption layer is a layer for preventing cracking at the time of application of an impact to the foregoing gas barrier layer or inorganic compound layer. Though a raw material forming the impact absorption layer is not particularly limited, for example, acrylic resins, urethane based resins, silicone based resins, olefin based resins, rubber based materials, and the like can be used. Of these, acrylic resins, silicone based resins, and rubber based materials are preferable.

Examples of the acrylic resin include acrylic resins containing, as a main component, at least one member selected among (meth)acrylic acid ester homopolymers, copolymers containing two or more (meth)acrylic acid ester units, and copolymers of a (meth)acrylic acid ester with other functional monomer.

As the (meth)acrylic acid ester, a (meth)acrylic acid ester in which a carbon number of an ester moiety thereof is from 1 to 20 is preferably used, and a (meth)acrylic acid ester in which a carbon number of an ester moiety thereof is from 4 to 10 is more preferably used. Examples of such a (meth)acrylic acid ester include butyl (meth)acrylate, pentyl (meth)acrylate, hexyl (meth)acrylate, heptyl (meth)acrylate, octyl (meth)acrylate, 2-ethylhexyl (meth)acrylate, nonyl (meth)acrylate, decyl (meth)acrylate, and the like.

Examples of the silicone based resin include silicone based resins containing, as a main component, dimethylsiloxane.

Examples of the rubber based material include rubber based materials containing, as a main component, an isoprene rubber, a styrene-butadiene rubber, a polyisobutylene rubber, a styrene-butadiene-styrene rubber, etc.; and the like. Incidentally, as the raw material forming the impact absorption layer, commercially available products can also be used.

In addition, the impact absorption layer may contain other components such as various additives, for example, an antioxidant, a plasticizer, an ultraviolet light absorber, a coloring agent, an antistatic agent, etc.

A method for forming the impact absorption layer is not particularly limited. For example, similar to the method for forming the adhesive layer, there is exemplified a method in which an impact absorption layer forming solution containing the foregoing raw material forming the impact absorption layer and if desired, other components such as a solvent, etc. is applied on a layer to be laminated, the obtained coating film is dried, and heating or the like is performed as the need arises, thereby forming the impact absorption layer. In addition, separately, there may be adopted a method in which an impact absorption layer is subjected to film formation on a release base material, and the obtained film is

transferred onto a layer to be laminated, followed by lamination.

A thickness of the impact absorption layer is usually from 1 to 100 μm, and preferably from 5 to 50 μm.

(Conductor layer)

The conductor layer is a layer which is provided for the purpose of bringing conductivity in the case of imparting an antistatic performance or in the case of using the adhesive sheet as an electrode. Examples of a material constituting the conductor layer include metals, alloys, metal oxides, electrically conductive compounds, and mixtures thereof, and the like. Specifically, examples thereof include antimony-doped tin oxide (ATO); fluorine-doped tin oxide (FTO); conductive metal oxides such as tin oxide, zinc oxide, indium oxide, indium tin oxide (ITO), indium zinc oxide (IZO), etc.; metals such as gold, silver, chromium, nickel, etc.; mixtures of these metal and conductive metal oxide; inorganic conductive substances such as copper iodide, copper sulfide, etc.; organic conductive materials such as polyaniline, polythiophene, polypyrrole, etc.; and the like. The conductor layer may be a laminate obtained by laminating a plurality of layers composed of such a material.

Of these, from the standpoint of transparency, conductive metal oxides are preferable, and ITO is more preferable.

Examples of a method for forming the conductor layer include a vapor deposition method, a sputtering method, an ion plating method, a thermal CVD method, a plasma CVD method, and the like. Of these, in view of the fact that a conductor layer can be formed simply and easily, a sputtering method is preferable.

The sputtering method is a method in which a discharge gas (argon, etc.) is introduced into a vacuum vessel, a high-frequency voltage or a direct current voltage is applied between a target and a substrate, thereby plasmatizing the discharge gas, and the resulting plasma is collided with the target to fly the target material and attach it to the substrate, thereby obtaining a thin film. As the target, a target made of a material which forms the foregoing conductor layer is used.

Though a thickness of the conductor layer may be properly chosen depending upon an application thereof or the like, it is usually from 10 nm to 50 μm, and preferably from 20 nm to 20 μm. A surface resistivity of the obtained conductor layer is usually not more than 1,000 Ω/□.

If desired, the formed conductor layer may be subjected to patterning as the need arises. Examples of a method for performing patterning include chemical etching by means of photolithography or the like, physical etching using a laser or the like, a vacuum vapor deposition method or a sputtering method using a mask, a lift-off method, a printing method, and the like.

(Primer layer)

The primer layer plays a role in enhancing interlayer adhesion with the base material layer, the gas barrier layer, the adhesive layer, or other layer. By providing the primer layer, it is possible to obtain an adhesive sheet with extremely excellent interlayer adhesion and surface smoothness.

A material constituting the primer layer is not particularly limited, and a known material can be used. Examples thereof include silicon-containing compounds; polymerizable compositions containing a photopolymerizable compound composed of a photopolymerizable monomer and/or a photopolymerizable prepolymer and at least a polymerization initiator capable of generating a radical with light in a visible light region; resins such as polyester based resins, polyurethane based resins (in particular, two-pack type curable resins between a polyacrylic polyol, a polyester polyol, a polyether polyol, etc. and an isocyanate compound), acrylic resins, polycarbonate based resins, a vinyl chloride/vinyl acetate copolymer, polyvinyl butyral based resins, nitrocellulose based resins, etc.; alkyl titanates; ethyleneimine; and the like. Such a material may be used solely or in combination of two or more kinds thereof.

The primer layer can be formed by applying a primer layer forming solution having the foregoing material constituting the primer layer dissolved or dispersed in an appropriate solvent on one surface or both surfaces of a layer on which the primer layer is to be formed and drying the obtained coating film and performing heating as the need arises.

As a method for applying the primer layer forming solution on a layer to be formed, a usual wet coating method can be adopted. Examples thereof include a dipping method, roll coating, gravure coating, knife coating, air knife coating, roll knife coating, die coating, a screen printing method, spray coating, a gravure offset method, and the like.

As a method for drying the coating film of the primer layer forming solution, a conventionally known drying method such as hot air drying, heat roll drying, infrared ray irradiation, etc. can be adopted. A thickness of the primer layer is usually from 10 to 1,000 nm.

In addition, the obtained primer layer may be subjected to ion implantation in the same method as the foregoing method for implanting an ion into the gas barrier layer. By implanting an ion into the primer layer, too, it is possible to obtain an adhesive sheet with more excellent gas barrier properties.

A shape of the adhesive sheet according to the present invention is not particularly limited, and examples

thereof include a sheet form. In the case of use as an electronic device member as described later, the adhesive sheet is preferably in a sheet form.

[Adhesive sheet]

A visible light transmittance of the adhesive sheet according to the present invention at a wavelength of 550 nm is preferably 85 % or more, more preferably 88 % or more, and still more preferably 90 % or more. When the visible light transmittance is 85 % or more, the adhesive sheet can be suitably used as an electronic device member as described later, for example, for an encapsulation application in an organic EL element. Incidentally, the visible light transmittance of the adhesive sheet can be measured using a known visible light transmittance measuring apparatus, and in the present invention, it means a value measured by the method described in the Examples.

A water vapor transmission rate of the whole of the adhesive sheet having the gas barrier layer and adhesive layer according to the present invention is preferably not more than 1.0 $g/m^2$/day, more preferably not more than 0.5 $g/m^2$/day, and still more preferably not more than 0.1 $g/m^2$/day under an atmosphere at 40°C and a relative humidity of 90 %.

In addition, as described above, the adhesive sheet according to the present invention is excellent in the resistance to folding, and therefore, even when subjected to folding or the like, it is able to keep the gas barrier properties. A water vapor transmission rate of the whole of the adhesive sheet after a folding test described in the Examples is preferably not more than 1.0 $g/m^2$/day, more preferably not more than 0.5 $g/m^2$/day, and still more preferably not more than 0.1 $g/m^2$/day under an atmosphere at 40°C and a relative humidity of 90 %.

[Electronic device]

The adhesive sheet according to the present invention can be used as an electronic device member, for example, for an encapsulation application in an organic EL element. The adhesive sheet according to the present invention has excellent gas barrier properties and the like, and therefore, for example, it is able to prevent deterioration of an organic EL element used in an electronic device, or the like. An example of an organic EL element using the adhesive sheet according to the present invention is shown in FIG. 2. In this organic EL element 10, a structure 14 in which a transparent electrode, a hole transport layer, a light emitting layer, a back electrode, and the like are laminated on a glass substrate 12. An adhesive sheet 1 according to the present invention has a configuration in which a gas barrier layer 3 and an adhesive layer 4 are laminated on a base material 2. When the adhesive layer 4 of this adhesive sheet 1 according to the present invention is brought into close contact with the structure 14 and the glass substrate 12 and adhered thereto, the structure 14 is encapsulated.

In the organic EL element 10, after forming the structure 14 on the glass substrate 12, the adhesive sheet 16 according to the present invention is stuck, thereby achieving the encapsulation. In accordance with the adhesive sheet according to the present invention, the element can be encapsulated simply and easily.

The electronic device according to the present invention is provided with the adhesive sheet according to the present invention as an electronic device member. The adhesive sheet according to the present invention has excellent gas barrier properties, transparency and resistance to folding, and the like, and therefore, it can be used for various electronic devices. Examples of the electronic device according to the present invention include liquid crystal displays, organic EL displays, inorganic EL displays, electronic papers, solar batteries, and the like.

[Examples]

The present invention is hereunder described in more detail with reference to the following Examples. However, it should be construed that the present invention is not limited to the following Examples at all.

A plasma ion implantation apparatus, an XPS measuring apparatus, a film density measuring apparatus by the X-ray reflectometry, a method of folding test, water vapor transmission rate measuring apparatus and measurement condition, a method of water vapor transmission test of end of adhesive layer, a measuring method of adhesive force, and a visible light transmittance measuring apparatus, all of which were used, are as follows.

(Plasma ion implantation apparatus)

RF power supply: Model Number "RF56000", manufactured by JEOL Ltd.

High-voltage pulse power supply: "PV-3-HSHV-0835", manufactured by Kurita Seisakusho Co., Ltd.

Incidentally, the used plasma ion implantation apparatus is an apparatus for implanting an ion using an external electric field.

A condition of the plasma ion implantation is shown below.

- Plasma generating gas: Ar
- Gas flow rate: 100 sccm
- Duty ratio: 0.5 %
- Iterative frequency: 1,000 Hz
- Impressed voltage: -10 kV
- RF power supply: Frequency: 13.56 MHz, Impressed electric power: 1,000 W
- Chamber internal pressure: 0.2 Pa
- Pulse width: 5 μsec
- Treatment time (ion implantation time): 5 minutes
- Conveyance speed: 0.2 m/min

(XPS measuring apparatus)

The measurement of existing proportions of an oxygen atom, a nitrogen atom, and a silicon atom in a surface layer part of the gas barrier layer (in the vicinity of 5 nm from the surface) was performed by means of elemental analysis by the X-ray photoelectron spectroscopy (XPS) using an XPS measuring apparatus. The measuring apparatus and measurement condition are as follows.

Measuring apparatus: "PHI Quantera SXM", manufactured by ULVAC-PHI, Incorporated
X-Ray source: AlKα
X-Ray beam diameter: 100 μm
Electric power value: 25 W
Voltage: 15 kV
Take-off angle: 45°
Degree of vacuum: $5.0 \times 10^{-8}$ Pa

(Film density measuring apparatus by the X-ray reflectometry)

The film density in the surface layer part of the gas barrier layer was calculated from a value obtained by measuring a reflectance of X-rays under a measurement condition shown below and determining a critical total reflection angle $\theta_c$. The measuring apparatus and measurement condition are as follows.

Measuring apparatus: Horizontal sample mount X-ray diffractometer for thin film evaluation, "SmartLab", manufactured by Rigaku Corporation
Measurement condition:

X-Ray source: Cu-Kα1 (wavelength: 1.54059 angstroms)
Optical system: Parallel beam optical system
Incident-side slit system: Ge(220) 2-crystal, Height-limiting slit: 5 mm, Incident slit: 0.05 mm
Light receiving-side slit system: Light-receiving slit: 0.10 mm, Solar slit: 5°
Detector: Scintillation counter
Tube voltage·tube current: 45 kV-200 mA
Scan axis: 2θ/θ
Scanning mode: Continuous scanning
Scan range: 0.1 to 3.0 deg.
Scan speed: 1 deg./min
Sampling interval: 0.002°/step

Incidentally, the existing proportions of an oxygen atom, a nitrogen atom, and a silicon atom in the surface layer part of the gas barrier layer as obtained by the X-ray photoelectron spectroscopy were used for the atomic number ratio ($x_i$ in the foregoing Equation 4).

(Method of folding test)

The adhesive sheet was folded in a half at the center in such a manner that the surface layer part of the gas barrier layer thereof was positioned outside and allowed to pass between two rolls of a laminating machine (a product name: "LAMIPACKER LPC1502", manufactured by Fujipla, Inc.) under a condition at a laminating speed of 5 m/min and a temperature of 23°C. Thereafter, the folded portion was observed using a microscope (magnification: 100), thereby

observing the presence or absence of the generation of cracking in the gas barrier layer. The case where the generation of cracking was not observed was evaluated as "None", and the case where the generation of cracking was observed was evaluated as "Occurred".

(Water vapor transmission rate measuring apparatus and measurement condition)

The water vapor transmission rate of the adhesive sheet ("Water vapor transmission rate before folding" in Table 1) was measured using a water vapor transmission rate tester (a product name: "L89-500", manufactured by LYSSY) when the water vapor transmission rate was 0.01 $g/m^2$/day or more and "deltaperm", manufactured by TECHNOLOX when the water vapor transmission rate was less than 0.01 $g/m^2$/day, respectively under a condition at 40°C and a relative humidity of 90 %. In addition, the water vapor transmission rate of the adhesive sheet after the foregoing folding test ("Water vapor transmission rate after folding" in Table 1) was also similarly measured.

However, the water vapor transmission rate of the adhesive layer was measured regarding a configuration in which a "polyethylene terephthalate film (a trade name: "K200-6E", manufactured by Mitsubishi Plastics Inc., thickness: 6 μm) (hereinafter also referred to as "6 μm-thick PET")" was stuck on the both surfaces of a 50 μm-thick adhesive layer, i.e., (6 μm-thick PET)/(50 μm-thick adhesive layer)/(6 μm-thick PET).

(Method of water vapor transmission test of end of adhesive layer)

The adhesive sheet for water vapor transmission test of an end of the adhesive was cut in a picture frame form having external dimensions of 60 mm × 60 mm and a width of 2 mm, a release sheet of the light releasing force type was peeled off, and the resultant was stuck onto a glass plate of 70 mm × 70 mm × 2 mm in thickness. Subsequently, a release sheet of the heavy releasing force type was peeled off, a humidity indicator seal (a product name: "RH-70", manufactured by Asey Industry Co., Ltd.) was stuck onto the inside of the picture frame of the adhesive sheet, and the resulting picture frame was then stuck onto another glass plate in such a manner that a space in the inside of the picture frame was encapsulated by the two glass plates and the adhesive sheet, thereby fabricating a "test material". The fabricated test material was allowed to stand under an atmosphere at 60°C and a relative humidity of 90 %, and thereafter, the humidity within the picture frame was evaluated. Incidentally, the used humidity indicator seal is colored from white to blue at a relative humidity of 70 %, and its accuracy is ±5 % RH (RH: relative humidity) at 25°C. The evaluation criteria are as follows.

AA: Not changed in color of the humidity indicator seal
BB: Slightly changed in color of the humidity indicator seal

(Measuring method of adhesive force)

After the fabrication, the adhesive sheet was allowed to adhere onto a stainless steel plate under an atmosphere at 23°C and 50 % RH and stuck in conformity with the measurement method of adhesive force of JIS Z0237 (revised on 2000) and after elapsing 24 hours, was measured with respect to peel adhesive strength (N/25 mm) at 180°.

(Visible light transmittance measuring apparatus)

A visible light transmittance (%) of the adhesive sheet was measured at a measurement wavelength of 550 nm using a visible light transmittance measuring apparatus ("UV-3101PC", manufactured by Shimadzu Corporation).

<Fabrication of gas barrier layer-provided base material>

The following polysilazane compounds A and B were used, respectively as a material of the gas barrier layer material.

- Polysilazane compound A: A coating material containing perhydropolysilazane as a main component (a trade name: "AQAMIKA NL110-20", manufactured by Clariant (Japan) K.K.)
- Polysilazane compound B: A coating material containing a mixture of organopolysilazane compounds having a saturated hydrocarbon group as a main component (a trade name: "tutoProm Bright", manufactured by Clariant (Japan) K.K.)

(Manufacturing Example 1)

On a polyethylene terephthalate film ("PET38 T-100", manufactured by Mitsubishi Plastics Inc., thickness: 38 μm, hereinafter referred to as "PET film") as a base material, the polysilazane compound A was applied by means of spin coating and heated at 120°C for one minute, thereby forming a polysilazane layer as a perhydropolysilazane-containing layer having a thickness of 60 nm on the PET film. Subsequently, the surface of the perhydropolysilazane-containing layer was subjected to plasma ion implantation with argon (Ar) using the plasma ion implantation apparatus, thereby fabricating a "gas barrier layer 1-provided base material".

(Manufacturing Example 2)

A "gas barrier layer 2-provided base material" was obtained in the same manner as that in Manufacturing Example 1, except for changing the heating time from one minute to 5 minutes.

(Manufacturing Example 3)

A "gas barrier layer 3-provided base material" was obtained in the same manner as that in Manufacturing Example 2, except for changing the thickness of the perhydropolysilazane-containing layer to be formed on the PET film from 60 nm to 100 nm.

(Manufacturing Example 4)

A "gas barrier layer 4-provided base material" was obtained in the same manner as that in Manufacturing Example 2, except for changing the thickness of the perhydropolysilazane-containing layer to be formed on the PET film from 60 nm to 150 nm.

(Manufacturing Example 5)

A "gas barrier layer 5-provided base material" was obtained in the same manner as that in Manufacturing Example 1, except for changing the heating time from one minute to 20 minutes.

(Manufacturing Example 6)

A "gas barrier layer 6-provided base material" was obtained in the same manner as that in Manufacturing Example 2, except for using nitrogen ($N_2$) as the plasma generating gas in place of argon.

(Manufacturing Example 7)

A "gas barrier layer 7-provided base material" was obtained in the same manner as that in Manufacturing Example 2, except for changing the impressed voltage at the time of performing the ion implantation from -10 kV to -5 kV.

(Manufacturing Example 8)

A "gas barrier layer 8-provided base material" was obtained in the same manner as that in Manufacturing Example 2, except for changing the impressed voltage at the time of performing the ion implantation from -10 kV to -15 kV.

(Manufacturing Example 9)

A "gas barrier layer 9-provided base material" was obtained in the same manner as that in Manufacturing Example 2, except for using the polysilazane compound B in place of the polysilazane compound A.

(Manufacturing Example 10)

A "gas barrier layer 10-provided base material" was obtained in the same manner as that in Manufacturing Example 2, except for using hydrogen ($H_2$) as the plasma generating gas in place of argon.

(Manufacturing Example 11)

A "gas barrier layer 11-provided base material" was obtained in the same manner as that in Manufacturing Example 2, except for using oxygen ($O_2$) as the plasma generating gas in place of argon.

(Manufacturing Example 12)

A "gas barrier layer 12-provided base material" was obtained in the same manner as that in Manufacturing Example 2, except for using helium (He) as the plasma generating gas in place of argon.

(Manufacturing Example 13)

A "gas barrier layer 13-provided base material" was obtained in the same manner as that in Manufacturing Example 2, except for using neon (Ne) as the plasma generating gas in place of argon.

(Manufacturing Example 14)

A "gas barrier layer 14-provided base material" was obtained in the same manner as that in Manufacturing Example 2, except for using xenon (Xe) as the plasma generating gas in place of argon.

(Manufacturing Example 15)

A "gas barrier layer 15-provided base material" was obtained in the same manner as that in Manufacturing Example 2, except for using krypton (Kr) as the plasma generating gas in place of argon.

(Manufacturing Example 16)

A "gas barrier layer 16-provided base material" was obtained in the same manner as that in Manufacturing Example 2, except for not performing the ion implantation.

(Manufacturing Example 17)

A film of silicon nitride (SiN) having a thickness of 60 nm was provided on the PET film by the sputtering method, thereby obtaining a "gas barrier layer 17-provided base material".

<Fabrication of adhesive composition>

(Manufacturing Example A)

100 parts by mass of "OPPANOL B50 (manufactured by BASF SE, Mw: 340,000)" as a polyisobutylene resin, 30 parts by mass of "NISSEKI POLYBUTENE Grade HV-1900 (manufactured by Nippon Oil Corporation, Mw: 1,900)" as a polybutene resin, and 50 parts by mass of "Eastotac H-100L Resin (manufactured by Eastman Chemical Company, Mw: 1,000)" as a cyclic olefin based polymer were dissolved in toluene to obtain an "adhesive composition A" having a solid contents concentration of about 18 % by mass.

(Manufacturing Example B)

An "adhesive composition B" was obtained in the same manner as that in Manufacturing Example A, except that in Manufacturing Example A, the polyisobutylene based resin was changed to "OPPANOL B30SF (manufactured by BASF SE, Mw: 200,000)".

(Manufacturing Example C)

An "adhesive composition C" was obtained in the same manner as that in Manufacturing Example A, except that in Manufacturing Example A, the polyisobutylene based resin was changed to "OPPANOL B80SF (manufactured by BASF SE, Mw: 750,000)"; and that the polybutene resin was not added.

(Manufacturing Example D)

100 parts by mass of "OPPANOL B50 (manufactured by BASF SE, Mw: 340,000)" and 30 parts by mass of "OPPANOL B30SF (manufactured by BASF SE, Mw: 200,000)" as polyisobutylene resins, and 30 parts by mass of "ARKON P-100 (manufactured by Arakawa Chemical Industries, Ltd.)" as a hydrogenated petroleum resin were dissolved in toluene to obtain an "adhesive composition D" having a solid contents concentration of about 18 % by mass.

(Manufacturing Example E)

An "adhesive composition E" was obtained in the same manner as that in Manufacturing Example E, except that in Manufacturing Example D, the amount of the "OPPANOL B30SF" was changed from 30 parts by mass to 10 parts by mass.

(Manufacturing Example F)

An "adhesive composition F" was obtained in the same manner as that in Manufacturing Example A, except that in Manufacturing Example A, 0.5 parts by mass of "TINUVIN 765 (manufactured by Ciba Japan K.K.)" as a hindered amine based light stabilizer and 0.5 parts by mass of "IRGANOX 1010 (manufactured by Ciba Japan K.K.)" as a hindered phenol based antioxidant were further added.

(Manufacturing Example G)

TN-560 (manufactured by MORESCO Corporation) as a rubber based adhesive was dissolved in toluene to obtain an "adhesive composition G" having a solid contents concentration of about 20 % by mass.

(Manufacturing Example H)

PK (a trade name, manufactured by Lintec Corporation) as an acrylic solvent type adhesive was used as an "adhesive composition H".

<Fabrication of adhesive sheet>

(Examples 1 to 22 and Comparative Examples 1 to 3)

Adhesive sheets of Examples 1 to 22 and Comparative Examples 1 to 3 were fabricated in the following manner by using the above-obtained adhesive compositions and the gas barrier layer-provided base materials obtained in Manufacturing Examples 1 to 17. A combination of the adhesive composition and the gas barrier layer-provided base material is shown in Table 1.

Each of the foregoing adhesive compositions A to H was applied in a film thickness after drying of 20 μm on a release treated surface of a release sheet of the light releasing force type (a trade name: "SP-PET1031", manufactured by Lintec Corporation) using a roll knife coater and dried at 100°C for about one minute to form an adhesive layer. Subsequently, the gas barrier layer surface of each of the foregoing gas barrier layer 1-provided base material to gas barrier layer 17-provided base material was laminated and stuck onto the adhesive surface, thereby obtaining an adhesive sheet.

<Fabrication of adhesive sheet for water vapor transmission test of end of adhesive>

For the water vapor transmission test of an end of the adhesive, an adhesive composition corresponding to each of the Examples and Comparative Examples was applied in a film thickness after drying of 50 μm on a release treated surface of a release sheet of the heavy releasing force type (a trade name: "SP-PET3811", manufactured by Lintec Corporation) using a roll knife coater and dried at 100°C for about one minute to form an adhesive layer having a thickness of 50 μm. Subsequently, the obtained adhesive layer was laminated and stuck onto the base material surface of each of the adhesive sheets of Examples 1 to 22, wherein Example 22 is an example which does not fall under the scope of the invention, and Comparative Examples 1 to 3, thereby obtaining an adhesive sheet for the water vapor transmission test of an end of the adhesive ((release sheet of the heavy releasing force type)/(50 μm-thick adhesive layer)/(PET film)/(20 μm-thick adhesive layer)/(release sheet of the light releasing force type)).

Measurement results and test results of the foregoing various physical property values with respect to the above-fabricated adhesive sheets of Examples 1 to 22, wherein Example 22 is an example which does not fall under

the scope of the invention, and Comparative Examples 1 to 3 are shown in Table 1.

Table 1

| | Base material | Gas barrier layer | | | | | | | | |
|---|---|---|---|---|---|---|---|---|---|---|
| | | Gas barrier layer | Silazane based compound | Heating time (min) | Film thickness (nm) | Plasma generating gas | Impressed voltage (kV) | Existing proportion in surface layer part (%) | | |
| | | | | | | | | Oxygen | Nitrogen | Silicon |
| Example 1 | PET | Gas barrier layer 1 | A | 1 | 60 | Ar | -10 | 63.22 | 7.21 | 29.57 |
| Example 2 | PET | Gas barrier layer 2 | A | 5 | 60 | Ar | -10 | 63.05 | 5.89 | 31.06 |
| Example 3 | PET | Gas barrier layer 3 | A | 5 | 100 | Ar | -10 | 63.21 | 5.69 | 31.10 |
| Example 4 | PET | Gas barrier layer 4 | A | 5 | 150 | Ar | -10 | 63.10 | 5.36 | 31.54 |
| Example 5 | PET | Gas barrier layer 5 | A | 20 | 60 | Ar | -10 | 63.54 | 5.13 | 31.33 |
| Example 6 | PET | Gas barrier layer 6 | A | 5 | 60 | $N_2$ | -10 | 69.51 | 1.40 | 29.09 |
| Example 7 | PET | Gas barrier layer 7 | A | 5 | 60 | Ar | -5 | 67.68 | 2.47 | 29.85 |
| Example 8 | PET | Gas barrier layer 8 | A | 5 | 60 | Ar | -15 | 69.01 | 0.15 | 30.84 |
| Example 9 | PET | Gas barrier layer 9 | B | 5 | 60 | Ar | -10 | 60.58 | 5.21 | 34.21 |
| Example 10 | PET | Gas barrier layer 10 | A | 5 | 60 | $H_2$ | -10 | 71.00 | 0.19 | 28.81 |
| Example 11 | PET | Gas barrier layer 11 | A | 5 | 60 | $O_2$ | -10 | 68.21 | 2.22 | 29.57 |
| Example 12 | PET | Gas barrier layer 12 | A | 5 | 60 | He | -10 | 71.60 | 0.68 | 27.72 |
| Example 13 | PET | Gas barrier layer 13 | A | 5 | 60 | Ne | -10 | 70.22 | 1.67 | 28.11 |

| | | | | | | | | | | |
|---|---|---|---|---|---|---|---|---|---|---|
| Example 14 | PET | Gas barrier layer 14 | A | 5 | 60 | Xe | -10 | 65.82 | 4.73 | 29.45 |
| Example 15 | PET | Gas barrier layer 15 | A | 5 | 60 | Kr | -10 | 66.80 | 3.59 | 29.61 |
| Example 16 | PET | Gas barrier layer 2 | A | 5 | 60 | Ar | -10 | 63.05 | 5.89 | 31.06 |
| Example 17 | PET | Gas barrier layer 2 | A | 5 | 60 | Ar | -10 | 63.05 | 5.89 | 31.06 |
| Example 18 | PET | Gas barrier layer 2 | A | 5 | 60 | Ar | -10 | 63.05 | 5.89 | 31.06 |
| Example 19 | PET | Gas barrier layer 2 | A | 5 | 60 | Ar | -10 | 63.05 | 5.89 | 31.06 |
| Example 20 | PET | Gas barrier layer 2 | A | 5 | 60 | Ar | -10 | 63.05 | 5.89 | 31.06 |
| Example 21 | PET | Gas barrier layer 2 | A | 5 | 60 | Ar | -10 | 63.05 | 5.89 | 31.06 |
| Example 22 | PET | Gas barrier layer 2 | A | 5 | 60 | Ar | -10 | 63.05 | 5.89 | 31.06 |
| Comparative Example 1 | PET | - | - | - | - | - | - | - | - | - |
| Comparative Example 2 | PET | Gas barrier layer 16 | A | 5 | 60 | - | - | 63.32 | 4.20 | 32.48 |
| Comparative Example 3 | PET | Gas barrier layer 17 | (SiN) | - | (60) | - | - | 64.78 | 0.01 | 35.21 |

Table 1 (Cont'd.)

| | Gas barrier layer | | Adhesive layer | | | | Visible light transmittance (%) | Water vapor transmission rate before folding (g/m²/day) | Water vapor transmission rate after folding (g/m²/day) |
|---|---|---|---|---|---|---|---|---|---|
| | Film density (g/cm³) | Presence or absence of cracking in folded portion | Adhesive composition | Water vapor transmission rate (g/m²/day) | Water vapor transmission of end | Adhesive force (N/25 mm) | | | |
| Example 1 | 2.60 | None | Composition A | 5.5 | AA | 16 | 90 | 0.20 | 0.32 |
| Example 2 | 3.28 | None | Composition A | 5.5 | AA | 16 | 90 | 0.03 | 0.07 |
| Example 3 | 3.37 | None | Composition A | 5.5 | AA | 16 | 90 | 0.01 | 0.01 |
| Example 4 | 3.56 | None | Composition A | 5.5 | AA | 16 | 90 | 0.01 | 0.01 |
| Example 5 | 3.19 | None | Composition A | 5.5 | AA | 16 | 90 | 0.03 | 0.08 |
| Example 6 | 3.32 | None | Composition A | 5.5 | AA | 16 | 90 | 0.04 | 0.08 |
| Example 7 | 2.76 | None | Composition A | 5.5 | AA | 16 | 91 | 0.05 | 0.07 |
| Example 8 | 3.02 | None | Composition A | 5.5 | AA | 16 | 89 | 0.01 | 0.08 |
| Example 9 | 2.54 | None | Composition A | 5.5 | AA | 16 | 88 | 0.07 | 0.08 |
| Example 10 | 2.71 | None | Composition A | 5.5 | AA | 16 | 90 | 0.07 | 0.08 |
| Example 11 | 3.15 | None | Composition A | 5.5 | AA | 16 | 90 | 0.05 | 0.09 |
| Example 12 | 2.63 | None | Composition A | 5.5 | AA | 16 | 89 | 0.05 | 0.07 |
| Example 13 | 2.70 | None | Composition A | 5.5 | AA | 16 | 90 | 0.05 | 0.07 |
| Example 14 | 2.91 | None | Composition A | 5.5 | AA | 16 | 90 | 0.07 | 0.09 |
| Example 15 | 2.89 | None | Composition A | 5.5 | AA | 16 | 90 | 0.08 | 0.10 |
| Example 16 | 3.28 | None | Composition B | 5.5 | AA | 21 | 90 | 0.03 | 0.07 |
| Example 17 | 3.28 | None | Composition C | 4.5 | AA | 5 | 90 | 0.03 | 0.07 |
| Example 18 | 3.28 | None | Composition D | 5.5 | AA | 16 | 90 | 0.03 | 0.07 |
| Example 19 | 3.28 | None | Composition E | 5.5 | AA | 18 | 90 | 0.03 | 0.07 |
| Example 20 | 3.28 | None | Composition F | 5.4 | AA | 16 | 90 | 0.03 | 0.07 |
| Example 21 | 3.28 | None | Composition G | 20.0 | BB | 25 | 90 | 0.03 | 0.07 |
| Example 22 | 3.28 | None | Composition H | 20.1 | BB | 11.6 | 90 | 0.03 | 0.07 |
| Comparative Example 1 | - | None | Composition A | 5.5 | AA | 16 | 91 | 12.00 | 12.00 |

| | | | | | | | | | |
|---|---|---|---|---|---|---|---|---|---|
| Comparative Example 2 | 1.63 | None | Composition A | 5.5 | AA | 16 | 92 | 10.32 | 10.92 |
| Comparative Example 3 | 2.30 | Occurred (cracked) | Composition A | 5.5 | AA | 16 | 71 | 0.25 | 1.21 |

From Table 1, the adhesive sheets of the Examples having the gas barrier layer satisfying the foregoing requirements (a) to (c) had a small water vapor transmission rate and high gas barrier properties as compared with the adhesive sheets of Comparative Examples 1 to 3 not satisfying the subject requirements. In addition, in the water vapor transmission test of an end of the adhesive layer, the penetration of water from an end of the adhesive layer was not substantially observed, and furthermore, the adhesive force was sufficient.

In addition, after the folding test, in the adhesive sheets of the Examples, the generation of cracking in the gas barrier layer was not observed, whereas in Comparative Example 3 in which the inorganic film (silicon nitride film) was formed, the generation of cracking was observed. In addition, in comparison with Comparative Example 3, the adhesive sheets of the Examples were small in an increase of the water vapor transmission rate, excellent in the resistance to folding, and furthermore, they were excellent in the transparency.

[Industrial Applicability]

The adhesive sheet according to the present invention is useful for electronic devices such as organic transistors, organic memories, electrochromics, etc., displays such as LCD, touch panels, electronic papers, etc., photoelectric conversion devices such as solar batteries, etc., and various electronic devices such as electrochemical light emitting devices, thermoelectric conversion devices, piezoelectric conversion devices, etc.

[Explanations of Letters or Numerals]

1, 1a, 1b, 1c: Adhesive sheet
2, 2a, 2b: Base material
3, 3a, 3b: Gas barrier layer
4, 4a, 4b, 4c: Adhesive layer
10: Organic EL element
12: Glass substrate
14: Structure

## Claims

1. An adhesive sheet comprising a base material having thereon at least a gas barrier layer and an adhesive layer, wherein
   the gas barrier layer is constituted of a material containing at least an oxygen atom and a silicon atom;
   in a surface layer part of the gas barrier layer, an existing proportion of an oxygen atom is from 60 to 75 %, an existing proportion of a nitrogen atom is from 0 to 10 %, and an existing proportion of a silicon atom is from 25 to 35 % relative to a total existing amount of the oxygen atom, the nitrogen atom, and the silicon atom, measured according to the method disclosed in the description; the film density in the surface layer part of the gas barrier layer is from 2.4 to 4.0 g/cm$^3$, measured according to the method disclosed in the description; the adhesive force of the adhesive sheet, measured after elapsing 24 hours according to JIS Z0237 (revised on 2000) is 3 N/25 mm or more; the water vapor transmission rate of the adhesive layer at a thickness of 50 $\mu$m is not more than 25 g/m$^2$/day under an atmosphere at 40°C and a relative humidity of 90 %, measured according to "(Water vapor transmission rate measuring apparatus and measurement condition)" disclosed in the description; and
   the adhesive material of the adhesive layer is a rubber based adhesive comprising a polyisobutylene based resin.

2. The adhesive sheet according to claim 1, wherein the material constituting the gas barrier layer is composed of a polysilazane compound.

3. The adhesive sheet according to claim 2, wherein the polysilazane compound is a perhydropolysilazane.

4. The adhesive sheet according to any one of claims 1 to 3, wherein the gas barrier layer is formed by implanting an ion.

5. The adhesive sheet according to claim 4, wherein the ion is one formed by ionizing at least one gas selected from the group consisting of hydrogen, nitrogen, oxygen, argon, helium, neon, xenon, and krypton.

6. The adhesive sheet according to claim 1, wherein the weight average molecular weight of the polyisobutylene based

resin is from 200,000 to 1,000,000, calculated as a reduced value into polystyrene which is measured by gel permeation chromatography (GPC).

7. The adhesive sheet according to claim 1 or 6, wherein the adhesive material of the adhesive layer is a rubber based adhesive comprising the polyisobutylene based resin and a polybutene resin.

8. The adhesive sheet according to claim 7, wherein the weight average molecular weight of the polybutene resin is from 500 to 100,000, calculated as a reduced value into polystyrene which is measured by gel permeation chromatography (GPC).

9. The adhesive sheet according to claim 7 or 8, wherein the content of the polybutene resin is from 10 to 100 parts by mass based on 100 parts by mass of the polyisobutylene based resin.

10. The adhesive sheet according to any one of claims 1 or 6 to 9, wherein the rubber based adhesive comprises further a cyclic olefin based polymer.

11. The adhesive sheet according to claim 10, wherein the weight average molecular weight of the cyclic olefin based polymer is from 200 to 5,000, calculated as a reduced value into polystyrene which is measured by gel permeation chromatography (GPC).

12. The adhesive sheet according to claim 10 or 11, wherein the content of the cyclic olefin based polymer is from 10 to 300 parts by mass based on 100 parts by mass of the polyisobutylene based resin.

13. The adhesive sheet according to any one of claims 1 or 6 to 12, wherein the rubber based adhesive comprises further at least one compound selected from the group consisting of a hindered amine based light stabilizer and a hindered phenol based antioxidant.

14. An electronic device provided with the adhesive sheet according to any one of claims 1 to 13 as an electronic device member.

**Patentansprüche**

1. Eine Klebefolie, umfassend ein Basismaterial mit mindestens einer Gasbarriereschicht und einer Klebeschicht darauf, wobei
die Gasbarriereschicht aus einem Material zusammengesetzt ist, das mindestens ein Sauerstoffatom und ein Siliziumatom enthält;
in einem Teil der Oberflächenschicht der Gasbarriereschicht beträgt ein vorhandener Anteil eines Sauerstoffatoms 60 bis 75 %, ein vorhandener Anteil eines Stickstoffatoms 0 bis 10 % und ein vorhandener Anteil eines Siliziumatoms 25 bis 35 %, bezogen auf eine insgesamt vorhandene Menge von Sauerstoffatom, Stickstoffatom und Siliziumatom, gemessen nach der in der Beschreibung offenbarten Methode;
die Filmdichte im Teil der Oberflächenschicht der Gasbarriereschicht beträgt 2,4 bis 4 g/cm$^3$, gemessen nach der in der Beschreibung offenbarten Methode;
die Haftkraft der Klebefolie, gemessen nach Ablauf von 24 Stunden nach JIS Z0237 (überarbeitet 2000), beträgt 3 N/25 mm oder mehr;
die Wasserdampf-Durchlässigkeitsrate der Klebstoffschicht bei einer Dicke von 50 $\mu$m beträgt nicht mehr als 25 g/m$^2$/Tag unter einer Atmosphäre von 40 °C und einer relativen Feuchtigkeit von 90 %, gemessen nach "(Wasserdampf-Durchlässigkeitsrate Messapparatur und Messbedingung") offenbart in der Beschreibung; und das Klebematerial der Klebeschicht ist ein Klebstoff auf Gummibasis, enthaltend ein Harz auf Polyisobutylenbasis.

2. Die Klebefolie nach Anspruch 1, wobei das die Gasbarriereschicht bildende Material aus einer Polysilazanverbindung besteht.

3. Die Klebefolie nach Anspruch 2, wobei die Polysilazanverbindung ein Perhydropolysilazan ist.

4. Die Klebefolie nach einem der Ansprüche 1 bis 3, wobei die Gasbarriereschicht durch Einbringen eines Ions gebildet wird.

**5.** Die Klebefolie nach Anspruch 4, wobei das Ion durch Ionisieren von mindestens einem Gas, ausgewählt aus der Gruppe bestehend aus Wasserstoff, Stickstoff, Sauerstoff, Argon, Helium, Neon, Xenon und Krypton, gebildet wird.

**6.** Die Klebefolie nach Anspruch 1, wobei das gewichtsmittlere Molekulargewicht des Harzes auf Polyisobutylenbasis 200.000 bis 1.000.000 beträgt, berechnet als ein reduzierter Wert in Polystyrol, das mittels Gel-Permeations-Chromatographie (GPC) gemessen wird.

**7.** Die Klebefolie nach Anspruch 1 oder 6, wobei das Klebematerial der Klebeschicht ein Klebstoff auf Gummibasis ist, umfassend das Harz auf Polyisobutylenbasis und ein Polybutenharz.

**8.** Die Klebefolie nach Anspruch 7, wobei das gewichtsmittlere Molekulargewicht des Polybutenharzes 500 bis 100.000 ist, berechnet als ein reduzierter Wert in Polystyrol, das mittels Gel-Permeations-Chromatographie (GPC) gemessen wird.

**9.** Die Klebefolie nach Anspruch 7 oder 8, wobei der Gehalt des Polybutenharzes 10 bis 100 Massenteile, bezogen auf 100 Massenteile des Harzes auf Polyisobutylenbasis, beträgt.

**10.** Die Klebefolie nach einem der Ansprüche 1 oder 6 bis 9, wobei der Klebstoff auf Gummibasis außerdem ein Polymer auf Basis eines zyklischen Olefins umfasst.

**11.** Die Klebefolie nach Anspruch 10, wobei das gewichtsmittlere Molekulargewicht des Polymers auf Basis des zyklischen Olefins von 200 bis 5.000 beträgt, berechnet als ein reduzierter Wert in Polystyrol, das mittels Gel-Permeations-Chromatographie (GPC) gemessen wird.

**12.** Die Klebefolie nach Anspruch 10 oder 11, wobei der Gehalt des Polymers auf Basis des zyklischen Olefins 10 bis 300 Massenteile, bezogen auf 100 Massenteile des Harzes auf Polyisobutylenbasis, beträgt.

**13.** Die Klebefolie nach einem der Ansprüche 1 oder 6 bis 12, worin der Klebstoff auf Gummibasis weiterhin mindestens eine Verbindung, ausgewählt aus der Gruppe bestehend aus einem Lichtstabilisator auf Basis eines gehinderten Amins und einem Antioxidans auf Basis eines gehinderten Phenols, umfasst.

**14.** Eine elektronische Vorrichtung, die mit der Klebefolie nach einem der Ansprüche 1 bis 13 als ein elektronisches Bauelement versehen ist.

## Revendications

**1.** Feuille adhésive comprenant un matériau de base sur lequel se trouve au moins une couche barrière aux gaz et une couche adhésive, où
la couche barrière aux gaz est constituée d’un matériau contenant au moins un atome d’oxygène et un atome de silicium ;
dans une partie de couche de surface de la couche barrière aux gaz, une proportion existante d’un atome d’oxygène est comprise entre 60 et 75%, une proportion existante d’un atome d’azote est comprise entre 0 et 10%, et une proportion existante d’un atome de silicium est comprise entre 25 et 35% par rapport à une quantité totale existante de l’atome d’oxygène, de l’atome d’azote, et de l’atome de silicium, mesurée selon le procédé décrit dans la description ;
la densité de film dans la partie de couche de surface de la couche barrière aux gaz est comprise entre 2,4 et 4,0 g/$cm^3$, mesurée selon le procédé décrit dans la description ;
la force d’adhérence de la feuille adhésive, mesurée au bout de 24 heures selon la norme JIS Z0237 (révisée en 2000) est supérieure ou égale à 3 N/25 mm ;
le coefficient de transmission de vapeur d’eau de la couche adhésive à une épaisseur de 50 μm ne dépasse pas 25 g/$m^2$/jour dans une atmosphère à 40°C et une humidité relative de 90%, mesuré selon "(condition de mesure et appareil de mesure de coefficient de transmission de vapeur d’eau)" décrits dans la description ; et
le matériau adhésif de la couche adhésive est un adhésif à base de caoutchouc comprenant une résine à base de polyisobutylène.

**2.** Feuille adhésive selon la revendication 1, dans laquelle le matériau constituant la couche barrière aux gaz est constitué d’un composé polysilazane.

**3.** Feuille adhésive selon la revendication 2, dans laquelle le composé polysilazane est un perhydropolysilazane.

**4.** Feuille adhésive selon l'une quelconque des revendications 1 à 3, dans laquelle la couche barrière aux gaz est formée par implantation d'un ion.

**5.** Feuille adhésive selon la revendication 4, dans laquelle l'ion est un ion formé par ionisation d'au moins un gaz choisi dans le groupe constitué par l'hydrogène, l'azote, l'oxygène, l'argon, l'hélium, le néon, le xénon, et le krypton.

**6.** Feuille adhésive selon la revendication 1, dans laquelle le poids moléculaire moyen en poids de la résine à base de polyisobutylène est compris entre 200000 et 1000000, calculé en tant que valeur réduite en polystyrène qui est mesurée par chromatographie par perméation de gel (GPC).

**7.** Feuille adhésive selon la revendication 1 ou 6, dans laquelle le matériau adhésif de la couche adhésive est un adhésif à base de caoutchouc comprenant la résine à base de polyisobutylène et une résine de polybutène.

**8.** Feuille adhésive selon la revendication 7, dans laquelle le poids moléculaire moyen en poids de la résine de polybutène est compris entre 500 et 100000, calculé en tant que valeur réduite en polystyrène qui est mesurée par chromatographie par perméation de gel (GPC).

**9.** Feuille adhésive selon la revendication 7 ou 8, dans laquelle la teneur en résine de polybutène est comprise entre 10 et 100 parties en masse par rapport à 100 parties en masse de la résine à base de polyisobutylène.

**10.** Feuille adhésive selon l'une quelconque des revendications 1 ou 6 à 9, dans laquelle l'adhésif à base de caoutchouc comprend en outre un polymère à base d'oléfine cyclique.

**11.** Feuille adhésive selon la revendication 10, dans laquelle le poids moléculaire moyen en poids du polymère à base d'oléfine cyclique est compris entre 200 et 5000, calculé en tant que valeur réduite en polystyrène qui est mesurée par chromatographie par perméation de gel (GPC).

**12.** Feuille adhésive selon la revendication 10 ou 11, dans laquelle la teneur en polymère à base d'oléfine cyclique est comprise entre 10 et 300 parties en masse par rapport à 100 parties en masse de la résine à base de polyisobutylène.

**13.** Feuille adhésive selon l'une quelconque des revendications 1 ou 6 à 12, dans laquelle l'adhésif à base de caoutchouc comprend en outre au moins un composé choisi dans le groupe constitué d'un photostabilisant à base d'amine encombrée et d'un antioxydant à base de phénol encombré.

**14.** Dispositif électronique pourvu de la feuille adhésive selon l'une quelconque des revendications 1 à 13 en tant qu'élément de dispositif électronique.

[FIG. 1]

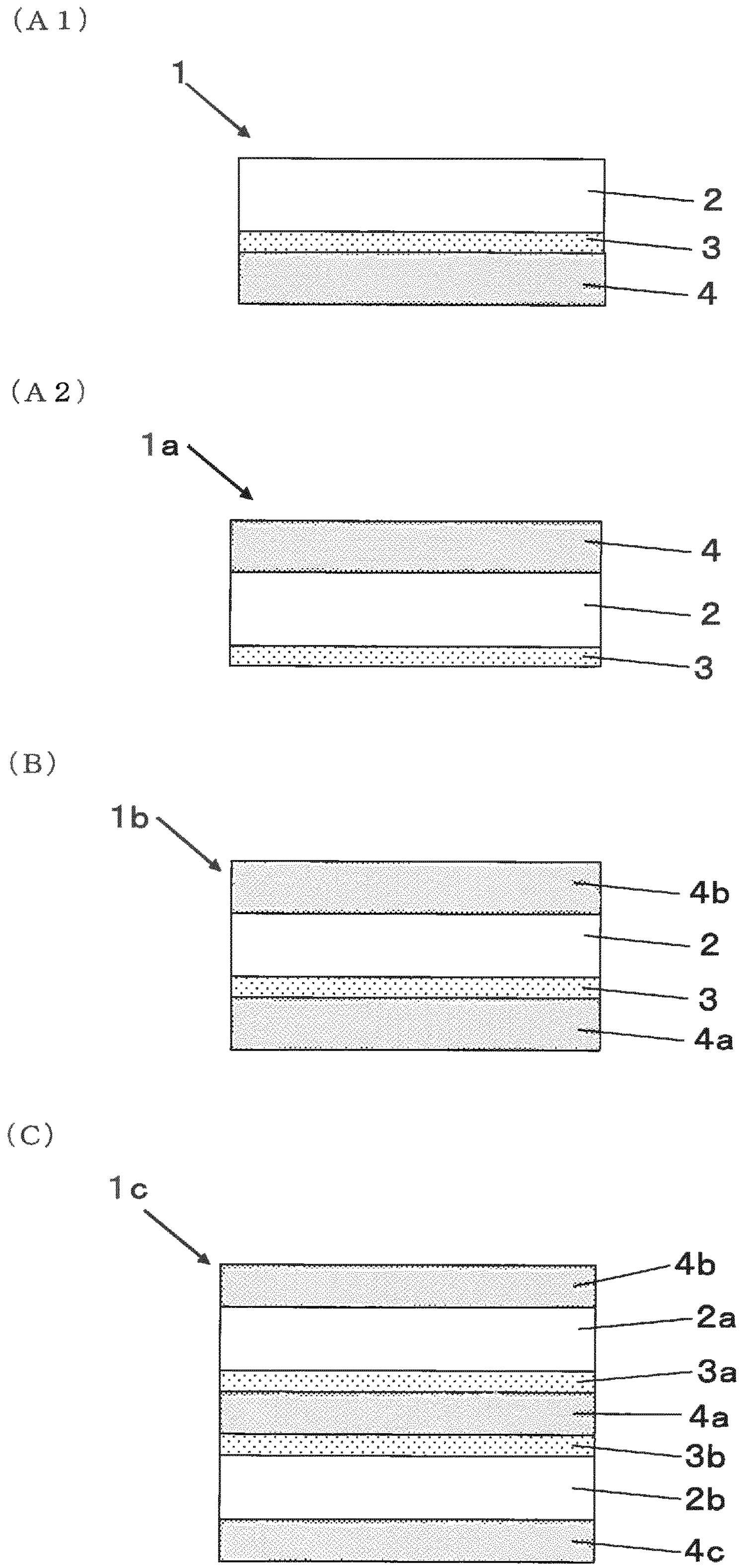

[FIG. 2]

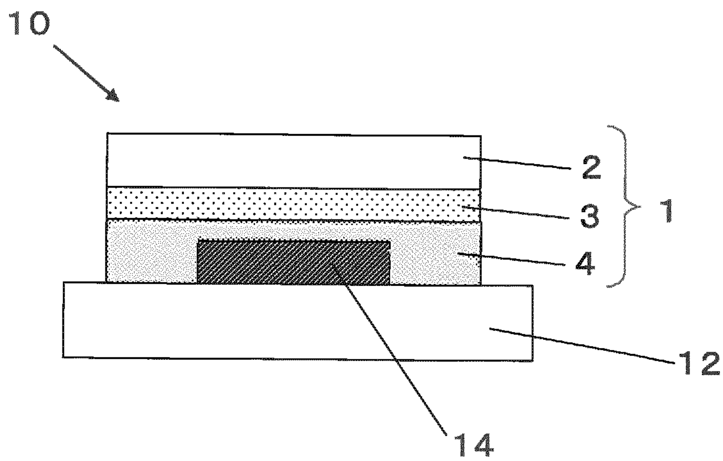

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2007237588 A
- JP 2007197517 A
- EP 2045355 A1
- JP 63016325 B
- JP 62195024 A
- JP 2084437 A
- JP 63081122 A
- JP 1138108 A
- JP 2175726 A
- JP 5238827 A
- JP 6122852 A
- JP 6306329 A
- JP 6299118 A
- JP 9031333 A
- JP 5345826 A
- JP 4063833 A
- JP 9143289 A
- NL 11020